# EUROPEAN PATENT SPECIFICATION

(11) **EP 4 492 244 B1**
(45) Date of publication and mention of the grant of the patent: **11.02.2026**
(21) Application number: 24165050.6
(22) Date of filing: 21.03.2024
(51) Int. Cl.: G06F 11/10

(54) **MEMORY CONTROLLER FOR PERFORMING EFFICIENT ERROR CORRECTION CODE (ECC) DECODING**
SPEICHERSTEUERUNG ZUR DURCHFÜHRUNG EINER EFFIZIENTEN FEHLERKORREKTURCODE-(ECC)-DECODIERUNG
CONTRÔLEUR DE MÉMOIRE POUR EFFECTUER UN DÉCODAGE DE CODE DE CORRECTION D'ERREUR EFFICACE (ECC)

(30) Priority: 10.07.2023 KR 20230089372; 12.09.2023 KR 20230121273
(43) Date of publication of application: 15.01.2025
(73) Proprietor: Samsung Electronics Co., Ltd., Suwon-si, Gyeonggi-do 16677 (KR)
(72) Inventor: SHIN, Junho, 16677 Suwon-si, Gyeonggi-do (KR); NA, Hanbyeul, 16677 Suwon-si, Gyeonggi-do (KR); JANG, Jaehun, 16677 Suwon-si, Gyeonggi-do (KR); SEO, Mankeun, 16677 Suwon-si, Gyeonggi-do (KR); SHIN, Dongmin, 16677 Suwon-si, Gyeonggi-do (KR)
(74) Representative: Kuhnen & Wacker Patent- und Rechtsanwaltsbüro PartG mbB

(56) References cited:
- US-A1- 2022 222 139
- US-A1- 2023 081 623
- US-A1- 2023 153 201

## Description

### Technical Field

The inventive concept relates to a memory controller, and more particularly, to a memory controller for performing efficient error correction code (ECC) decoding.

### Discussion of Related Art

Non-volatile memory devices include a plurality of memory cells capable of storing data in a non-volatile manner. Flash memory, an example of such devices, is widely used in cell phones, digital cameras, personal digital assistants (PDAs), mobile computing devices, and stationary computing devices, among others.

Memory devices are capable of writing or reading data through various methods. For example, in response to a read request, these devices may produce both hard decision data and soft decision data. Hard decision data is obtained using a normal read level having a certain voltage level, while soft decision data is obtained using an offset read level having a certain value that is offset from the normal read level. To correct data errors, a memory controller may perform soft decision error correction by using both hard decision data and soft decision data from a memory device.

However, in the soft decision error correction, the memory controller performs the error correction after both hard decision data and soft decision data are received. Accordingly, this approach may lead to longer error correction times and necessitate additional buffer space for the temporary storage of the hard decision data and/or soft decision data.

From US 2023/153201 A1 it is known a method of operating a memory controller that includes: collecting hard decision information based on data read from memory cells of a monitoring unit using a normal read level; collecting soft decision information based on data read from the monitoring unit using one or more offset read levels that are different from the normal read level; storing first strong error information determined based on the hard decision information and the soft decision information in a memory in the memory controller; and updating second strong error information determined for the monitoring unit in the memory after the first strong error information is stored.

From US 2023/081623 A1 it is known a non-volatile memory that uses hard bit and soft bit data in error correction operations. To reduce the amount of soft bit data that needs to be transferred from a memory to the controller and improve memory system performance, the soft bit data is compressed before transfer. After the soft bit data is read and stored into the internal data latches associated with the sense amplifiers, it is compressed within these internal data latches. The compressed soft bit data can then be transferred to the transfer data latches of a cache buffer, where the compressed soft bit data is consolidated and transferred out over an input-output interface.

### SUMMARY

The inventive concept provides a memory controller having improved efficiency in error correction code (ECC) decoding processing using hard decision data and soft decision data.

A memory controller according to the inventive concept is defined in independent claim 1. Further developments of the memory controller according to the inventive concept are defined in the dependent claims.

### BRIEF DESCRIPTION OF THE DRAWINGS

Embodiments of the inventive concept will be more clearly understood from the following detailed description taken in conjunction with the accompanying drawings in which:
FIG. 1 is a block diagram showing a memory system according to an embodiment;
FIGS. 2A and 2B are diagrams showing example generation of hard decision data and soft decision data;
FIG. 3 is a flowchart showing a method of operating a storage device, according to embodiments;
FIGS. 4A, 4B, and 4C are diagrams showing various formatting operations according to embodiments;
FIGS. 5A, 5B, 5C, and 5D are diagrams showing times required for error correction code (ECC) decoding processing according to embodiments;
FIGS. 6 and 7 are block diagrams showing examples of data formatters according to embodiments;
FIG. 8 is a flowchart showing a method of operating a memory device of FIG. 7;
FIGS. 9 and 10 are diagrams respectively showing an example of a data formatting operation and an example of the time required for ECC decoding processing in the memory device of FIG. 7;
FIG. 11 is a diagram schematically showing the structure of a memory device of FIG. 1, according to an embodiment;
FIG. 12 is a diagram illustrating a memory cell array of FIG. 1, according to an embodiment;
FIG. 13 is a perspective view showing a memory block according to an embodiment;
FIG. 14 is a block diagram showing a memory system according to another embodiment;
FIGS. 15, 16 and 17 are diagrams showing examples of ECC decoding processing and times required for the ECC decoding processing, according to some embodiments;
FIGS. 18A and 18B show examples of memory systems according to embodiments; and
FIG. 19 is a block diagram showing an example in which memory devices according to embodiments are applied to a solid state drive system.

### DETAILED DESCRIPTION OF THE EMBODIMENTS

Hereinafter, embodiments of the inventive concept are described in detail with reference to the accompanying drawings.

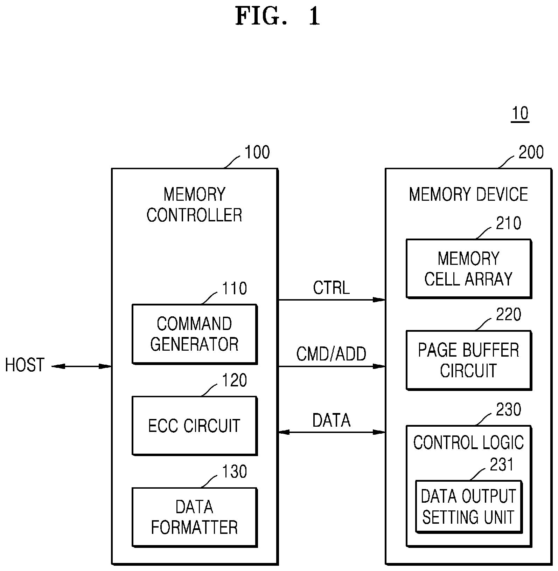

FIG. 1 is a block diagram showing a memory system 10 according to an embodiment.

Referring to FIG. 1, the memory system 10 may include a memory controller 100 and a memory device 200. The memory device 200 may include a memory cell array 210, a page buffer circuit 220, and a control logic 230. The control logic 230 may include a data output setting unit 231. Additionally, the memory controller 100 may include a command generator 110, and includes an error correction code (ECC) circuit 120, and a data formatter 130.

For example, the memory system 10 may communicate with a host via various interfaces, such as a universal serial bus (USB), a multimedia card (MMC), an embedded MMC (eMMC), a peripheral component interconnection (PCI), a PCI-express (PCI-E), an advanced technology attachment (ATA), a serial-ATA, a parallel-ATA, a small computer small interface (SCSI), an enhanced small disk interface (ESDI), integrated drive electronics (IDE), Firewire, a universal flash storage (UFS), and a nonvolatile memory express (NVMe).

According to an embodiment, the memory device 200 may include a non-volatile memory device, such as flash memory. In some embodiments, the memory system 10 may be embedded in an electronic device or provided as removable memory. For example, the memory system 10 may be provided in various forms, such as an embedded UFS memory device, an embedded multi-media card (eMMC), a solid state drive (SSD), a UFS memory card, a compact flash (CF) card, a secure digital (SD) card, a micro secure digital (Micro-SD) card, a mini secure digital (Mini-SD) card, an extreme digital (xD) card, and a memory stick. In addition, the memory system 10 stores data non-volatilely and may be thus referred to as a storage device.

The memory controller 100 may control the memory device 200 to read data stored in the memory device 200 or write data on the memory device 200, in response to a write/read request from a host HOST. For example, the memory controller 100 may provide an address ADD, a command CMD, and a control signal CTRL to the memory device 200 and control program and read and erase operations of the memory device 200. In addition, data DATA to be stored in the memory device 200 and data DATA read from the memory device 200 may be transmitted and received between the memory controller 100 and the memory device 200. For example, the memory controller 100 may include a processor, and the processor may control all operations in the memory controller 100 and memory operations of the memory device 200.

The memory cell array 210 may include a plurality of memory cells, and the plurality of memory cells may include, for example, flash memory cells. Hereinafter, embodiments in which a plurality of memory cells include Not AND (NAND) flash memory cells are described in detail as an example. However, the inventive concept is not limited thereto. In some embodiments, the plurality of memory cells may include resistive memory cells, such as resistive RAM (ReRAM) memory cells, phase change RAM (PRAM) memory cells, and magnetic RAM (MRAM) memory cells.

In an embodiment, the memory cell array 210 may include a 3-dimensional memory cell array, the 3-dimensional memory cell array may include a plurality of NAND strings, and each of the NAND strings may include memory cells respectively connected to word lines vertically stacked on a substrate. However, the inventive concept is not limited thereto. In some embodiments, the memory cell array 210 may include a 2-dimensional memory cell array and the 2-dimensional memory cell array may include a plurality of NAND strings arranged in row and column directions.

In response to a read command provided to the memory device 200 from the memory controller 100, a read operation may be performed under control of the control logic 230. For example, when each of the memory cells stores a plurality of bits, the memory cells of the memory cell array 210 may include a plurality of threshold voltage distributions, and data including two or more bits may be read from each of the memory cells.

The page buffer circuit 220 may store data in units of certain pages read from the memory cell array 210 and may include a plurality of page buffers respectively arranged to correspond to the plurality of bit lines. Additionally, each of the page buffers may include one or more latches, and information read from each of the memory cells during a read process may be stored in the one or more latches.

When determining data stored in the memory cell, a read operation using one or more read levels may be performed. For example, hard decision data and soft decision data may be read from each of the memory cells. The hard decision data may correspond to data based on a normal read level in a normal read operation. The soft decision data may correspond to data based on an offset read level that has a certain value offset from the normal read level. For example, the offset read level may include a read level with a positive (+) offset value and a read level with a negative (-) offset value compared to the normal read level, and the soft decision data may be generated based on a combination of read results according to the positive (+) offset value and negative (-) offset value.

The control logic 230 may control all operations of the memory device 200. For example, based on the command CMD, the address ADD, and the control signal CTRL received from the memory controller 100, the control logic 230 may output various internal control signals for programming data in the memory cell array 210 or reading data from the memory cell array 210. Additionally, according to an embodiment, the control logic 230 may control an internal operation of the memory device 200 to generate the hard decision data and the soft decision data in response to the read command provided from the memory controller 100. The memory controller 100 may perform ECC decoding processing using the received hard decision data and soft decision data. For example, the memory controller 100 may perform an error correction operation, such as low density parity check (LDPC).

The hard decision data and soft decision data described above may be provided to the memory controller 100 according to various policies. For example, when an error occurs in normal data (e.g., the hard decision data) read from the memory device 200, the memory device 200 may generate the soft decision data under the control of the memory controller 100. Additionally, regardless of the error detection result in the normal data, the memory device 200 may generate and provide the hard decision data and the soft decision data in response to the read command from the memory controller 100. Additionally, a separate read command that is different from the read command used to request the normal data may be established. Upon receiving this separate read command, the memory device 200 may generate the hard decision data and the soft decision data and output the hard decision data and the soft decision data to the memory controller 100.

As described above, the hard decision data and the soft decision data may be generated according to various policies. The memory device 200 described in the following embodiments generates the hard decision data and the soft decision data in response to the read command from the memory controller 100, regardless of the error detection result in the normal data, and provides the hard decision data and the soft decision data to the memory controller 100.

A specific example operation according to an embodiment is described below.

The command generator 110 may generate various types of commands for requesting writing and erasing of data, in addition to the read command. The command generator 110 may provide the read command to the memory device 200 and receive the hard decision data and the soft decision data from the memory device 200. For example, the memory device 200 may output the hard decision data to the memory controller 100 and then output the soft decision data. In other words, the hard decision data may be output prior to the soft decision data. Alternatively, the memory device 200 may output the soft decision data to the memory controller 100 and then output the hard decision data. In other words, the soft decision data may be output prior to the hard decision data. For example, the memory device 200 may adjust the order in which the hard decision data and the soft decision data are output, depending on an internal setting operation, a setting operation under control by the memory controller 100, or the type of commands received from the memory controller 100. In an embodiment, when the command generator 110 generates a first type of read command, the memory device 200 may output the hard decision data first. Additionally, when the command generator 110 generates a second type of read command, the memory device 200 may output the soft decision data first. The embodiment of FIG. 1 shows, as an example, a case where the data output setting unit 231 performs an internal setting operation according to setting information stored in the memory device 200 to thereby set the order in which the hard decision data and the soft decision data are output.

The ECC circuit 120 may correct data errors by ECC decoding processing using the hard decision data and/or soft decision data. For example, the ECC circuit 120 may include an ECC decoder, and the ECC decoder may correct errors using only the hard decision data or correct errors using the hard decision data and the soft decision data together. In an embodiment, ECC decoding processing using only the hard decision data may be referred to as normal decoding and ECC decoding processing using the hard decision data and the soft decision data together may be referred to as soft decision decoding.

In addition, the data formatter 130 may optimize data formatting for ECC decoding processing of the ECC circuit 120. The data formatter 130 may use the hard decision data and the soft decision data provided from the memory device 200, format them accordingly, provide the formatted hard decision data and soft decision data to the ECC circuit 120. For example, the data formatter 130 may perform a formatting operation to change the order in which the hard decision data and the soft decision data are input to the ECC circuit 120. For example, when one page includes a plurality of sectors and the hard decision data and the soft decision data are generated for each of the sectors, the data formatter 130 can execute a formatting operation that changes the sequence in which the hard decision data and the soft decision data of the plurality of sectors are provided to the ECC circuit 120.

For example, if a mode is set to output the hard decision data first, the hard decision data for the plurality of sectors may be output to the memory controller 100 first, and then, the soft decision data may be output to the memory controller 100. Alternatively, if a mode is set to output the soft decision data first, the soft decision data for the plurality of sectors may be output to the memory controller 100 first, and then, the hard decision data may be output to the memory controller 100. When both the hard decision data and the soft decision data are received for each of the sectors, the memory controller 100 may perform an ECC decoding operation on a corresponding sector.

The data formatter 130 performs a formatting operation on the hard decision data and the soft decision data received from the memory device 200. The data formatter 130 than provides the ECC circuit 120 with data in a format that may reduce the time required for ECC decoding processing. For example, the data formatter 130 may perform the formatting operation such that the hard decision data and the soft decision data are continuously provided to the ECC circuit 120 for each of the sectors. Additionally, the data formatter 130 may determine that error correction using the soft decision decoding does not need to be performed for a specific sector. Based on this determination, the data formatting may be performed such that the soft decision data is not provided to the ECC circuit 120 for at least one sector.

According to the embodiment described above, the memory controller 100 may provide the ECC circuit 120 with data in a format capable of performing fast ECC decoding processing, using the formatting operation on the hard decision data and the soft decision data for a plurality of sectors provided from the memory device 200. Accordingly, the operating performance of the memory system 10 employing the memory device 200 may be improved.

Additionally, the memory controller 100 may perform formatting operations according to the embodiments on the basis of hardware, software, or a combination thereof. For example, the memory controller 100 may include a processor and operating memory, a module (e.g., a data formatting module) that includes a set of commands related to formatting operations stored in the operating memory, and the processor may perform the formatting operations by executing the data formatting module.

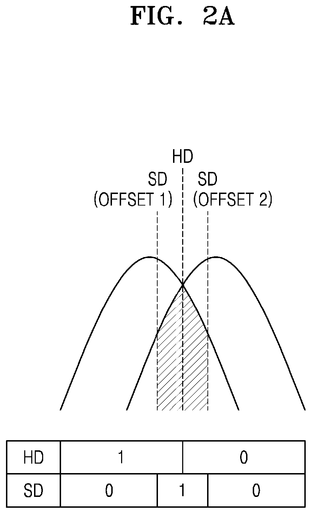

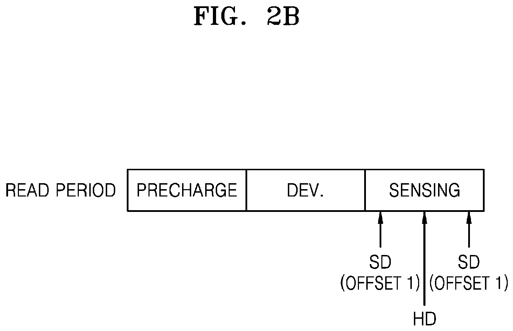

FIGS. 2A and 2B are diagrams showing, as an example, generation of the hard decision data and the soft decision data.

In an embodiment, the hard decision data and the soft decision data may be generated together in the same read operation. For example, the hard decision data and the soft decision data may be determined by different read levels, and the hard decision data corresponding to the normal read level and the soft decision data corresponding to the offset read level may be generated using different sensing timings in one sensing section. For example, when the sensing timing is relatively fast, a data value may be determined based on a relatively low threshold voltage level. On the other hand, when the sensing timing is relatively slow, the data value may be determined based on a relatively high threshold voltage level.

Referring to FIG. 1 and FIGS. 2A and 2B, the memory device 200 may output data based on the normal read level as hard decision data HD and output data based on the offset read level as soft decision data SD. The offset read level may include a first offset read level (Offset 1) having a level less than the normal read level by a first offset value and a second offset read level (Offset 2) having a level greater than the normal read level by a second offset value. The memory device 200 may generate the soft decision data SD on the basis of values determined using the first offset read level (Offset 1) and the second offset read level (Offset 2). The first offset vale and the second offset value may be equal to or different from each other.

For example, the hard decision data HD of a memory cell having a threshold voltage lower than the normal read level may have a value of "1" and the hard decision data HD of a memory cell having a threshold voltage higher than the normal read level may have a value of "0". The soft decision data SD of a memory cell having a threshold voltage lower than the first offset read level (Offset 1) or higher than the second offset read level (Offset 2) may have a value of "0". On the other hand, the soft decision data SD of a memory cell having a threshold voltage between the first offset read level (Offset 1) and the second offset read level (Offset 2) may have a value of "1". For example, the soft decision data SD having a value of "0" may have a strong error and the soft decision data SD having a value of "1" may have a weak error. When detecting/correcting data errors, various parameters, such as coefficients used in error correction calculations, may be calculated based on the hard decision data HD and the soft decision data SD generated as described above.

FIG. 2B shows an example in which hard decision data HD and soft decision data SD are generated by the same sensing operation.

The read operation may include a plurality of sections, for example, a precharge section, a develop section, and a sensing section. The precharge section, the develop section, and the sensing section may be arranged in sequence. In the precharge section, a voltage applied to a bit line may rise to a precharge voltage having a certain level. The voltage level of the bit line may change depending on the data stored in the memory cell during the develop section. For example, when the memory cell is programmed with a relatively low threshold voltage corresponding to an on-cell, the voltage level of the bit line may drop rapidly. On the other hand, when the memory cell is programmed with a relatively high threshold voltage corresponding to an off-cell, the voltage level of the bit line may drop gently.

In the sensing section, sensing operations may be performed at least two different times to determine the hard decision data HD and the soft decision data SD. For example, as the sensing time increases, the data value may be based on a relatively low read level. On the other hand, as the sensing timing decreases, the data value may be based on a relatively high read level. Depending on the sensing timing performed in the sensing section, the data value may be based on the first offset read level (Offset 1), the normal read level, and the second offset read level (Offset 2). Additionally, the hard decision data HD and the soft decision data SD may be generated by the sensing operations.

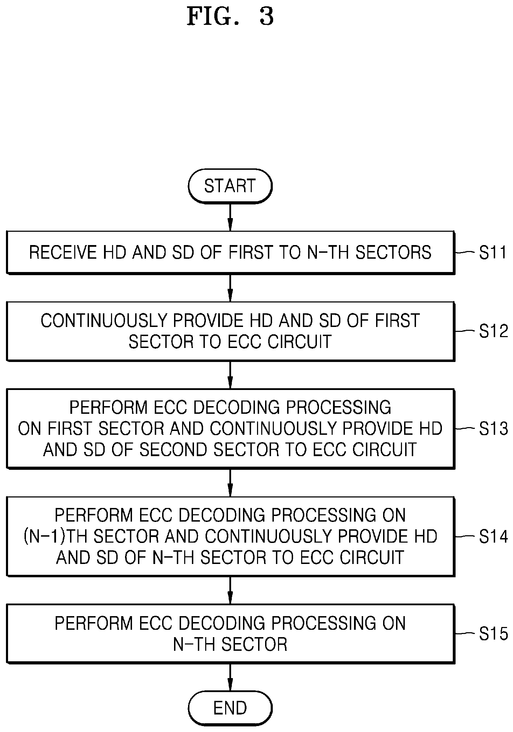

FIG. 3 is a flowchart showing a method of operating a storage device, according to embodiments. The embodiment of FIG. 3 shows an example in which one page includes first to N-th sectors, and hard decision data HD and soft decision data SD of each of the sectors are provided to a memory controller. When describing the following embodiments, the term "data" may refer to normal data (or hard decision data) provided to a host or may include both the hard decision data and soft decision data. In addition, the term "data" may refer to data of one sector or may include data of a plurality of sectors belonging to one page.

The memory controller may receive the hard decision data HD and the soft decision data SD on pages in a random order (S11). For example, depending on the settings of the memory device or a read command provided from the memory controller to the memory device, the memory controller may receive the hard decision data HD for the first to N-th sectors first or may receive the soft decision data SD for the first to N-th sectors first. The memory controller includes a data formatter, and the data formatter performs formatting operations on the received hard decision data HD and soft decision data SD.

For example, the data formatter may continuously (or sequentially) provide hard decision data HD and soft decision data SD of a first sector to an ECC circuit (S12). The ECC circuit may perform ECC decoding processing on the first sector, and the data formatter may continuously provide hard decision data HD and soft decision data SD of a second sector to the ECC circuit (S13). In other words, the ECC decoding processing may be performed on the first sector while receiving hard decision data HD and soft decision data SD of the second sector. For example, the ECC decoding processing on the first sector may be performed in parallel with the operation of providing the hard decision data HD and soft decision data SD of the second sector to the ECC circuit, and then, the ECC circuit may perform the ECC decoding processing on the second sector after the ECC decoding processing on the first sector is completed.

According to the above process, ECC decoding processing may be performed on all sectors of one page. For example, the ECC decoding processing may be performed on the (N-1)th sector, and the data formatter may provide hard decision data HD and soft decision data SD of the N-th sector to the ECC circuit (S14). As the ECC circuit performs the ECC decoding processing on the N-th sector (S15), the ECC decoding processing on the first to N-th sectors on the page may be completed.

According to the related art, when an ECC circuit performs ECC decoding processing on a specific sector, the ECC decoding for that sector needs to wait until the hard decision data HD or soft decision data SD of another sector is received. However, according to the embodiments described above, the ECC circuit may receive the hard decision data HD and soft decision data SD together, as an ECC decoding unit, for each of the first to N-th sectors, and thus, the ECC decoding processing speed may be improved.

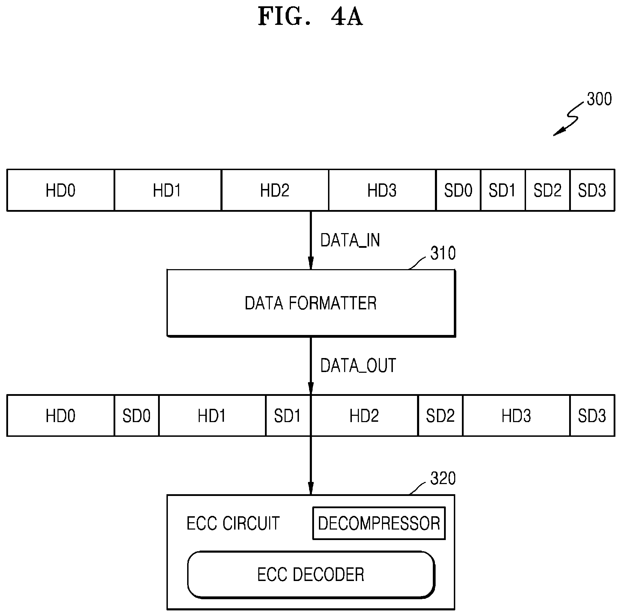

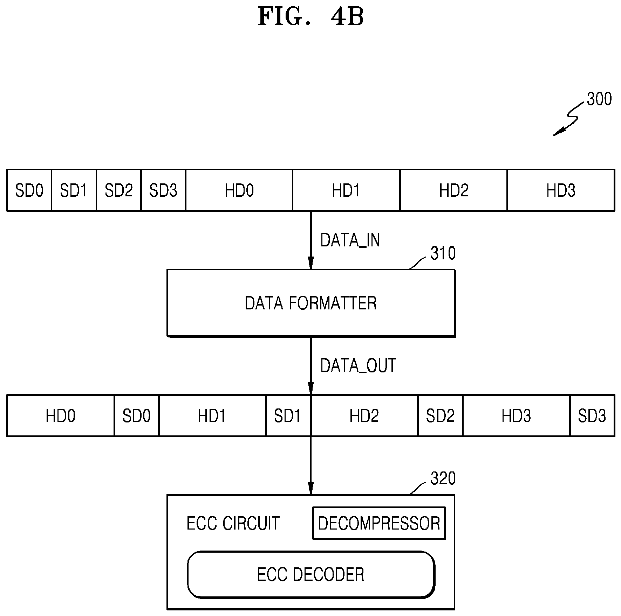

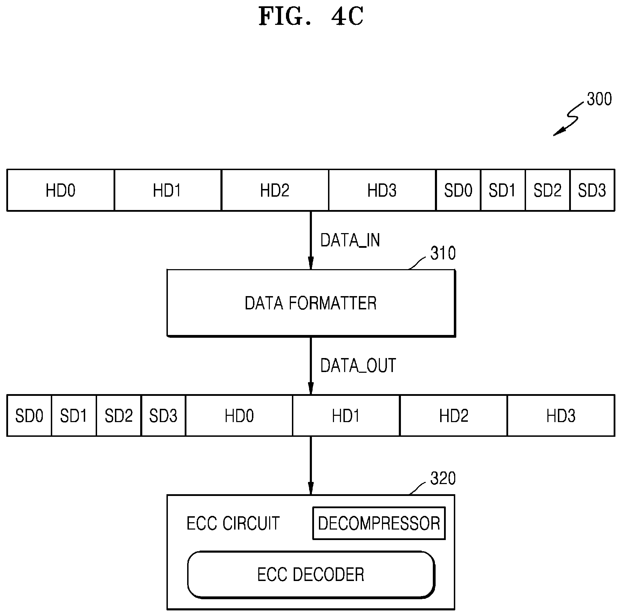

FIGS. 4A, 4B, and 4C are diagrams showing various formatting operations according to embodiments. When describing the embodiments below, a case, in which one page of a memory device includes first, second, third and fourth sectors and hard decision data and soft decision data are generated for each of the sectors, is described as an example. Additionally, one page may have a size of 16 Kbytes (KB), and each of the first to fourth sectors may have a size of 4 KB.

In an embodiment, the soft decision data of the first to fourth sectors may be compressed in a memory device and provided to a memory controller 300. Various types of compression algorithms, such as lossy compression and lossless compression, may be applied to the compression operation. For example, assuming that a compression ratio is 1/4, the hard decision data of each sector may have a size of 4 KB, but the soft decision data of each sector may have a size of 1 KB. The hard decision data of the first to fourth sectors may respectively correspond to first, second, third and fourth hard decision data HD0, HD1, HD2 and HD3 and the soft decision data of the first to fourth sectors may respectively correspond to first, second, third and fourth soft decision data SD0, SD1, SD2 and SD3.

The compressed soft decision data of the first to fourth sectors may be decompressed in the memory controller 300. For example, as shown in FIGS. 4A, 4B, and 4C, the decompression operation may be performed in an ECC circuit 320, and the ECC circuit 320 may include a decompressor. In the example shown in FIGS. 4A, 4B, and 4C, the decompressor and an ECC decoder are shown as separate components, but the decompressor may be provided in the ECC decoder.

As shown in FIG. 4A, the memory controller 300 may receive the first to fourth hard decision data HD0 to HD3 and the first to fourth soft decision data SD0 to SD3, which are read from one page. The first to fourth hard decision data HD0 to HD3 and the first to fourth soft decision data SD0 to SD3 may be sequentially received by the memory controller 300. For example, the memory controller 300 may receive the first to fourth hard decision data HD0 to HD3 and then receive the first to fourth soft decision data SD0 to SD3. A data formatter 310 receives data input Data_IN having a format corresponding to the order of data provided from the memory device, generates data output Data_OUT by performing a formatting operation to change the order of data received as the data input Data_IN, and provides the generated data output Data_OUT to the ECC circuit 320.

For example, as shown in FIG. 4A, the data formatter 310 may provide the first hard decision data HD0 and the first soft decision data SD0 to the ECC circuit 320 and then provide the second hard decision data HD1 and the second soft decision data SD1 to the ECC circuit 320. In addition, sequentially, the data formatter 310 may provide the third hard decision data HD2 and the third soft decision data SD2 to the ECC circuit 320 and then provide the fourth hard decision data HD3 and the fourth soft decision data SD3 to the ECC circuit 320. In this case, the ECC circuit 320 may continuously receive the hard decision data and soft decision data on a sector basis and immediately perform ECC decoding processing thereon. For example, the ECC circuit 320 may perform ECC decoding processing on the first sector at the time when the first soft decision data SD0 is completely received. In this case, the first sector may correspond to the first hard decision data HD0 and the first soft decision data SD0.

The memory controller 300 may generate a formatting result as shown in FIG. 4A based on its own formatting operation, irrespective of the order of data provided from the memory device. For example, as shown in FIG. 4B, the memory controller 300 may receive the first to fourth soft decision data SD0 to SD3 and then receive the first to fourth hard decision data HD0 to HD3. The memory controller 300 may provide the data output Data_OUT in the same order as in FIG. 4A by performing a formatting operation on the received data. For example, as shown in FIG. 4B, the data formatter 310 may provide the first hard decision data HD0 and the first soft decision data SD0 to the ECC circuit 320 and then provide the second hard decision data HD1 and the second soft decision data SD1 to the ECC circuit 320. In addition, sequentially, the third hard decision data HD2 and the third soft decision data SD2 may be provided to the ECC circuit 320, and then the fourth hard decision data HD3 and the fourth soft decision data SD3 may be provided to the ECC circuit 320.

The memory controller 300 may perform various other formatting operations on the first to fourth hard decision data HD0 to HD3 and the first to fourth soft decision data SD0 to SD3, which are provided from the memory device. For example, as shown in FIG. 4C, the memory controller 300 may receive the first to fourth hard decision data HD0 to HD3 and then receive the first to fourth soft decision data SD0 to SD3. The data formatter 310 may provide the first to fourth soft decision data SD0 to SD3 to the ECC circuit 320 by performing a formatting operation on the received data and then provide the first to fourth hard decision data HD0 to HD3 to the ECC circuit 320. In this case, the ECC circuit 320 may receive the first to fourth soft decision data SD0 to SD3 having a size of 4 KB and then immediately perform ECC decoding processing whenever hard decision data for each sector is received, rather than starting ECC decoding processing after receiving all the first to fourth hard decision data HD0 to HD3 having a size of 16 KB. Accordingly, the ECC decoding processing on the sectors of one page may be performed quicker.

Additionally, in an embodiment, the memory controller 300 may skip the formatting operation described in the above embodiments when the soft decision data of a plurality of sectors is first provided from the memory device. For example, when an operating environment of the memory device is set to output the soft decision data first, the memory controller 300 may receive data from the memory device in the order corresponding to the formatting result shown in FIG. 4C. As a result, the ECC decoding processing may be performed according to the order of data received from the memory device without the need to perform a separate formatting operation.

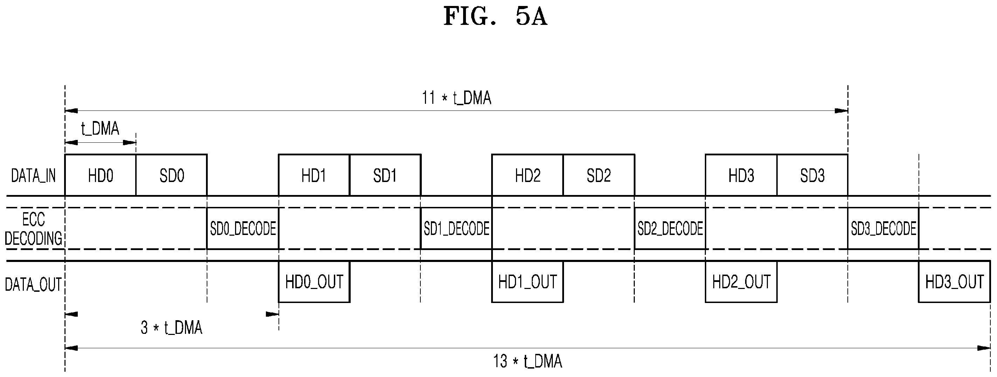

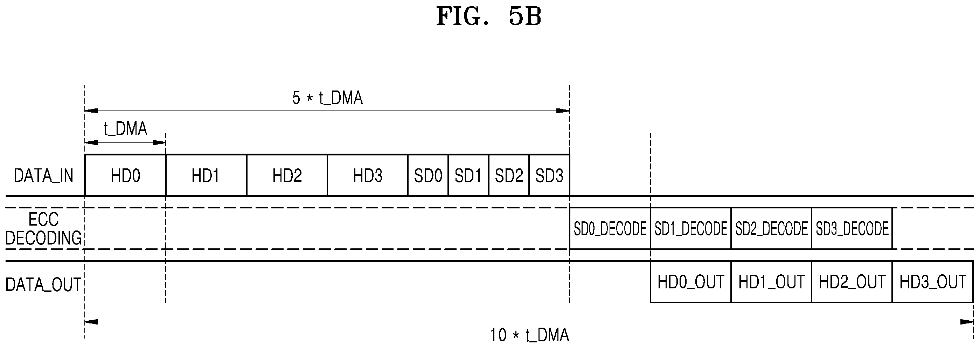

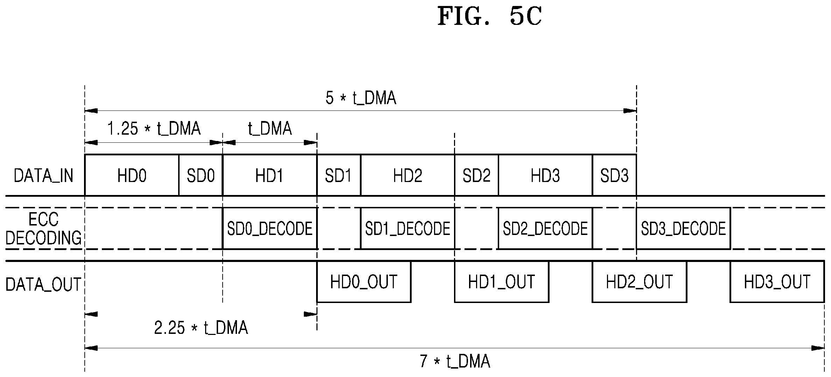

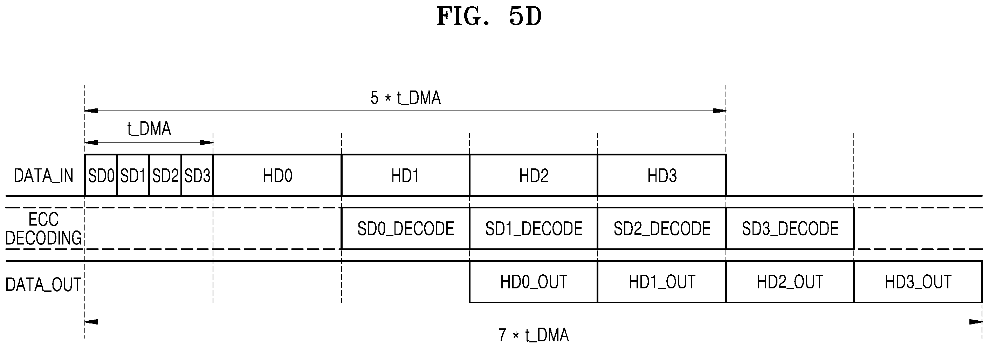

FIGS. 5A, 5B, 5C, and 5D are diagrams showing times required for ECC decoding processing according to embodiments. In FIGS. 5A, 5B, 5C, and 5D, data input Data_IN and data output Data_OUT represent data provided to an ECC circuit and data output from the ECC circuit, respectively. In the example shown in FIGS. 5A, 5B, 5C, and 5D, first, second, third and fourth soft decision decoding SD0_Decode, SD1_Decode, SD2_Decode and SD3_Decode may be performed corresponding to first to fourth sectors. In addition, t_DMA shown in FIGS. 5A, 5B, 5C, and 5D represents the time required to input and output data having a size of 4 KB. For example, the time required for each of soft decision decoding is assumed to correspond to 1*t_DMA.

FIGS. 5A and 5B illustrate a case in which the formatting operation according to embodiments is not performed.

FIG. 5A illustrates a case in which the hard decision data and the soft decision data are provided to the ECC circuit in units of 4 KB for each sector, without performing compression on the soft decision data. Referring to FIG. 5A, the first hard decision data HD0 and the first soft decision data SD0 of the first sector may be provided to the ECC circuit, and the ECC circuit may perform the first soft decision decoding SD0_Decode on the first sector. In this case, it may take time 3*t_DMA for the ECC circuit to receive the first hard decision data HD0 and the first soft decision data SD0 and perform the first soft decision decoding SD0_Decode.

An error in the first hard decision data HD0 may be corrected according to the result of soft decision decoding, and first data HD0_OUT in which the error is corrected (hereinafter, referred to as the error-corrected first data HD0_OUT) may be output. In addition, the second hard decision data HD1 and the second soft decision data SD1 of the second sector may be provided to the ECC circuit, and reception of the second hard decision data HD1 and output of the error-corrected first data HD0_OUT may be performed in parallel. Next, second data HD1_OUT in which an error is corrected according to the result of the second soft decision decoding SD1_Decode may be output. According to the above process, error-corrected third data HD2_OUT and error-corrected fourth data HD3_OUT may be output. In the example shown in FIG. 5A as described above, it may take time 13*t_DMA to output all error-corrected data of the first to fourth sectors. Further, it may take time 11*t_DMA to receive all the first to fourth hard decision data HD0 to HD3 and first to fourth soft decision data SD0 to SD3.

FIG. 5B illustrates a case in which the first to fourth soft decision data SD0 to SD3 are compressed, and then the first to fourth hard decision data HD0 to HD3 and the first to fourth soft decision data SD0 to SD3 are sequentially provided to the ECC circuit. Referring to FIG. 5B, it may take time 5*t_DMA to provide the first to fourth hard decision data HD0 to HD3 and the first to fourth soft decision data SD0 to SD3 to the ECC circuit. In an embodiment, the first to fourth soft decision data SD0 to SD3 may be decompressed in the ECC circuit, and the decompressed first to fourth soft decision data SD0 to SD3 may be used for the soft decision decoding.

The ECC circuit may perform the soft decision decoding by using both hard decision data and soft decision data, and thus, the soft decision decoding may be performed after the first to fourth soft decision data SD0 to SD3 are completely received. For example, after completely receiving the first to fourth soft decision data SD0 to SD3, the ECC circuit may sequentially perform the first to fourth soft decision decoding SD0_Decode to SD3_Decode on the first to fourth sectors. The ECC circuit may output error-corrected data immediately after the soft decision decoding is completed for each of the sectors. For example, after the first soft decision decoding SD0_Decode is performed, error-corrected first data HD0_OUT may be output, after the second soft decision decoding SD1_Decode is performed, error-corrected second data HD1_OUT may be output, and so forth. According to the example shown in FIG. 5B, it may take time 10*t_DMA to output all error-corrected data of the first to fourth sectors.

FIGS. 5C and 5D illustrate a case in which the formatting operation according to embodiments is performed.

Referring to FIG. 5C, the memory controller may perform a formatting operation on the first to fourth hard decision data HD0 to HD3 and the first to fourth soft decision data SD0 to SD3 which are received from the memory device and may provide the ECC circuit with data in a format that reduces the time required for ECC decoding processing. For example, the first hard decision data HD0 and the first soft decision data SD0 may be continuously provided to the ECC circuit by the formatting operation, and the time taken to perform this process may correspond to 1.25*t_DMA. While the first soft decision decoding SD0_Decode is performed on the first sector, the second hard decision data HD1 may be provided to the ECC circuit. Then, the second soft decision data SD1 may be continuously provided to the ECC circuit. According to an embodiment shown in FIG. 5C, it may take time 2.25*t_DMA to provide the ECC circuit with the hard decision data and soft decision data of one sector and then complete the soft decision decoding of this sector. In the embodiment shown in FIG. 5C, it may take time 7*t_DMA to output all error-corrected data of the first to fourth sectors.

Referring to FIG. 5D, the memory controller may perform formatting operations on the first to fourth hard decision data HD0 to HD3 and the first to fourth soft decision data SD0 to SD3 which are received from the memory device. The first to fourth soft decision data SD0 to SD3 may be provided to the ECC circuit, and then, the first to fourth hard decision data HD0 to HD3 may be provided to the ECC circuit. Since each soft decision data has a size of 1 KB, it may take time 1*t_DMA to provide the first to fourth soft decision data SD0 to SD3 to the ECC circuit.

The ECC circuit may perform first soft decision decoding SD0_Decode after the first hard decision data HD0 is received. The ECC circuit may perform second soft decision decoding SD1_Decode after the second hard decision data HD1 is received. Through the above process, it may take time 7*t_DMA to output all the error-corrected data of the first to fourth sectors.

According to the embodiments as described above, the time required for ECC decoding processing may be reduced when pieces of soft decision data are compressed and the formatting operations are applied to the data provided to the ECC circuit, compared to cases where neither compression is performed nor formatting operations are undertaken.

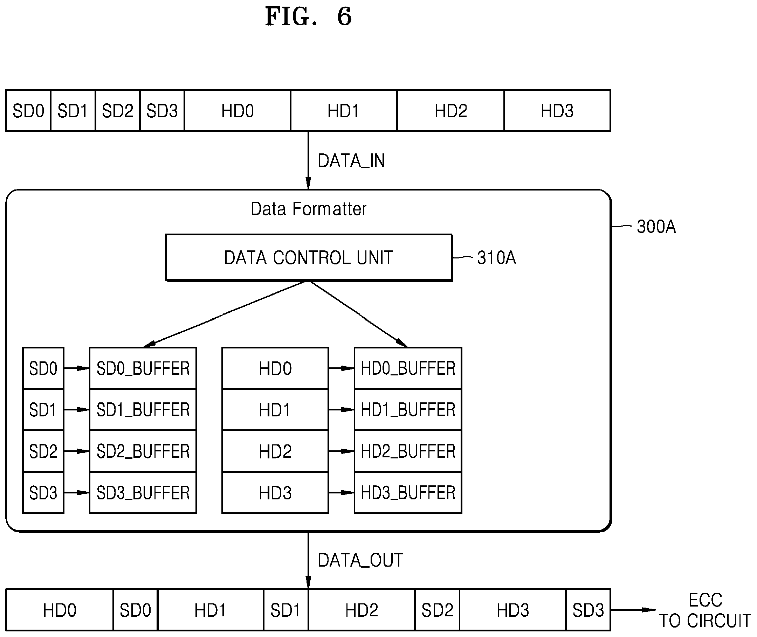

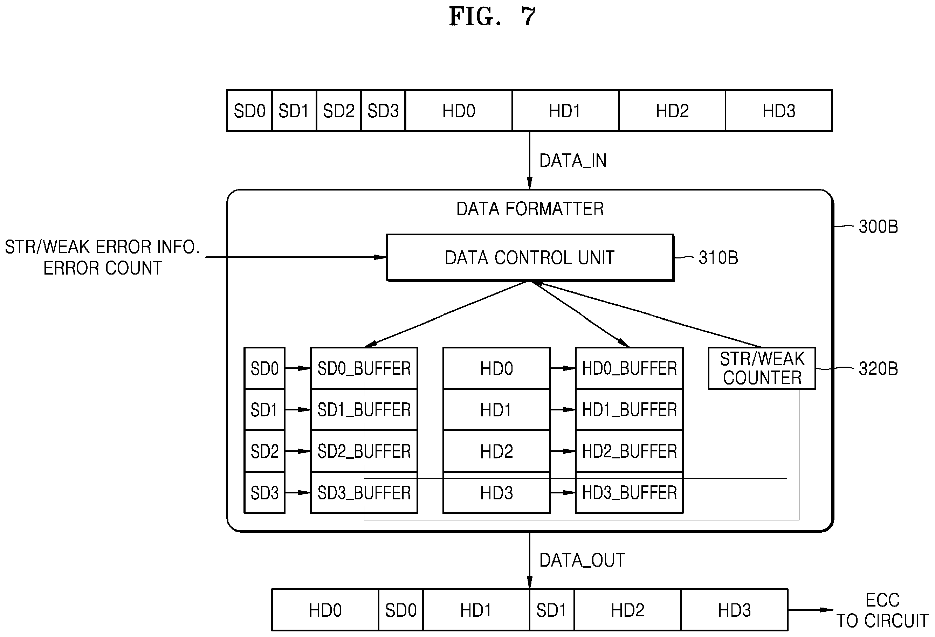

FIGS. 6 and 7 are block diagrams showing examples of data formatters 300A and 300B according to embodiments.

Referring to FIG. 6, the data formatter 300A may include a data control unit 310A and one or more buffers. The data control unit 310A may receive first to fourth hard decision data HD0 to HD3 and first to fourth soft decision data SD0 to SD3 and perform formatting operations on the first to fourth hard decision data HD0 to HD3 and the first to fourth soft decision data SD0 to SD3. The buffers of the data formatter 300A may include buffers storing the first to fourth hard decision data HD0 to HD3 and buffers storing the first to fourth soft decision data SD0 to SD3. FIG. 6 illustrates a case in which the first to fourth soft decision data SD0 to SD3 are provided to a memory controller, and then, the first to fourth hard decision data HD0 to HD3 are provided to the memory controller, but the inventive concept is not necessarily limited thereto.

According to the embodiments described above, the data control unit 310A may perform a formatting operation according to various methods. For example, the formatting operation may be performed such that the hard decision data and soft decision data of each sector are continuously provided to the ECC circuit. For example, the data control unit 310A may provide the first hard decision data HD0 and the first soft decision data SD0 of the first sector to the ECC circuit, provide the second hard decision data HD1 and the second soft decision data SD1 of the second sector to the ECC circuit, provide the third hard decision data HD2 and the third soft decision data SD2 of the third sector to the ECC circuit, and provide the fourth hard decision data HD3 and the fourth soft decision data SD3 of the fourth sector to the ECC circuit.

FIG. 7 illustrates a case in which the data formatter 300B does not output soft decision data of at least one sector based on results of the ECC decoding.

Referring to FIG. 7, the data formatter 300B may include a data control unit 310B, one or more buffers, and a counter 320B. According to the embodiment described above, the one or more buffers may include buffers HD0_Buffer to HD3_Buffer storing first to fourth hard decision data HD0 to HD3 and buffers SD0_Buffer to SD_3 Buffer storing first to fourth soft decision data SD0 to SD3. In an embodiment, the counter 320B may count strong error information (or weak error information) in each of the first to fourth soft decision data SD0 to SD3 and provide the counting result to the data control unit 310B. In addition, the data control unit 310B may receive at least one piece of decoding information according to the ECC decoding result. For example, at least one piece of decoding information may include information indicating the location of data, at which an actual error occurs, determined by ECC decoding processing (or whether the location at which the actual error occurs corresponds to a strong error or a weak error) and information indicating the number of errors occurring in one sector. Additionally, a loop counter that counts the number of loop executions during a soft decision decoding process may be further provided in the memory controller, and the data control unit 310B may further receive a counting value of the loop counter.

In an embodiment, when there are no soft errors in any one sector (e.g., the first sector) or the number of soft errors is very small, it is possible to correct these errors through ECC decoding processing that relies solely on hard decision data, without the need to perform soft decision decoding on the first sector. In addition, the first to fourth sectors belonging to one page are likely to have the same or similar error patterns. Accordingly, based on the ECC decoding result of at least one sector on one page, on which the ECC decoding processing has been performed, it is possible to determine whether to perform soft decision decoding on the subsequent sectors.

In an embodiment, the data control unit 310B may compare the counting value from the counter 320B with a first reference value and determine whether to perform soft decision decoding based on the comparison result. For example, the data control unit 310B may compare a value obtained by counting the number of strong errors (or weak errors) in each of the first to fourth sectors with the first reference value and perform the formatting operation such that soft decision data is not provided to the ECC circuit for some of the first to fourth sectors. Additionally, in an embodiment, when it is determined to perform soft decision decoding based on the counting value provided from the counter 320B, the data control unit 310B may randomly select a sector, on which soft decision decoding is not performed among the first to fourth sectors, without referring to the ECC decoding result of the previous sector.

Additionally, in an embodiment, the data control unit 310B may refer to the ECC decoding result of at least one sector on which ECC decoding processing has been performed. The embodiment of FIG. 7 describes a case in which a determination whether to perform soft decision decoding on the third and fourth sectors is based on the decoding information of the first and second sectors. According to the ECC decoding results of the first and second sectors, when one or more pieces of data in which an actual error has occurred correspond to the location of a strong error of the soft decision data or are very likely to correspond to the location of a strong error, it may be advantageous to perform ECC decoding processing using only hard decision data. In this case, as shown in FIG. 7, the data control unit 310B may selectively provide only hard decision data for the third and fourth sectors without providing soft decision data.

When the number of errors occurring in each of the first and second sectors is less than or equal to a second reference value, the errors are corrected or more likely to be corrected by normal decoding processing. In this case, as shown in FIG. 7, the data control unit 310B may provide only hard decision data for the third and fourth sectors.

When compression loss is large during the compression process on the first to fourth soft decision data SD0 to SD3 performed in the memory device or when the information of the first to fourth soft decision data SD0 to SD3 are incorrect due to a compression error, the number of times a loop is executed may increase significantly during the soft decision decoding process. The data control unit 310B compares the number of loop executions with a certain threshold. Based on the comparison result, the data control unit 310B may provide only hard decision data for the third and fourth sectors. In other words, when the compression characteristics of soft decision data are not good, the decoding operation using soft decision data may not be performed in some sectors.

Additionally, when the number of times the loop is executed during the soft decision decoding process is relatively small or less than a certain threshold, the number of errors occurring in the read data may be small. In this case, for the read data, errors are corrected or likely to be corrected only by decoding processing using hard decision data. Accordingly, in embodiments, it may be determined whether the number of loop executions is less than a certain threshold. Based on this determination, the decoding operation using soft decision data may not be performed in some sectors.

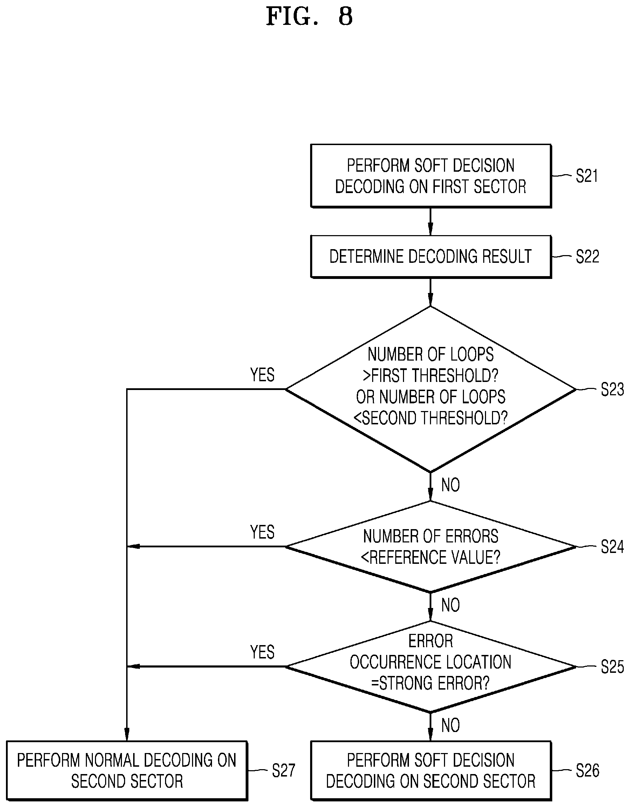

FIG. 8 is a flowchart showing a method of operating the memory device of FIG. 7.

Referring to FIG. 8, the memory controller may receive first to fourth hard decision data and first to fourth soft decision data for the first to fourth sectors from the memory device and perform formatting operations on the first to fourth hard decision data and the first to fourth soft decision data. Depending on the formatting result, the hard decision data and soft decision data of each of the sectors may be continuously provided to the ECC circuit. For example, the ECC circuit may perform soft decision decoding on the first sector (S21).

The ECC circuit may correct an error in the first sector by soft decision decoding for the first sector and provide at least one piece of decoding information according to the decoding result. The data formatter may determine the decoding result by the at least one piece of decoding information described above (S22) and control a formatting operation related to subsequent ECC decoding processing of the second sector on the basis of the determination result.

For example, the number of loop executions during the soft decision decoding process of the first sector may be compared with at least one threshold. For example, the number of loop executions may be compared with a first threshold or a second threshold (S23). In an embodiment, the first threshold may be greater than the second threshold. When the number of loop executions is greater than the first threshold or when the number of loop executions is less than the second threshold, the formatting operation may be performed such that the soft decision data of the second sector is not provided to the ECC circuit. Accordingly, a normal decoding operation may be performed on the second sector without using soft decision data (S27). In embodiments, the number of loop executions may be compared only with the first threshold, the number of loop executions may be compared only with the second threshold, or the number of loop executions may be compared with the first threshold and the second threshold together.

When the number of loop executions is not greater than the first threshold or not less than the second threshold, the number of errors occurring in the first sector may be compared with a reference value (S24). When the number of errors occurring in the first sector is less than the reference value, a normal decoding operation may be performed on the second sector without using soft decision data (S27). On the other hand, when the number of errors occurring in the first sector is not less than the reference value, the location of the actual error occurring in the first sector is determined. By referring to values of the soft decision data of the first sector, it may be determined whether the data in which the error has actually occurred corresponds to the location of a strong error in the soft decision data (S25). When the location at which the error has occurred corresponds to the strong error, the error may be corrected by a normal decoding operation using hard decision data without performing a soft decision decoding operation. Accordingly, the normal decoding operation may be performed on the second sector without using soft decision data (S27). On the other hand, when the location at which the error has occurred corresponds to a weak error, the soft decision decoding needs to be performed on the subsequent sectors as well. Accordingly, the hard decision data and soft decision data of the second sector are continuously provided to the ECC circuit, and the soft decision decoding may be performed on the second sector (S26).

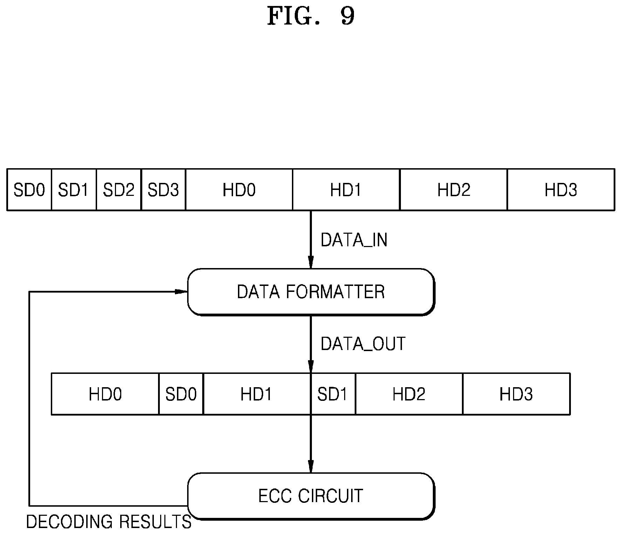

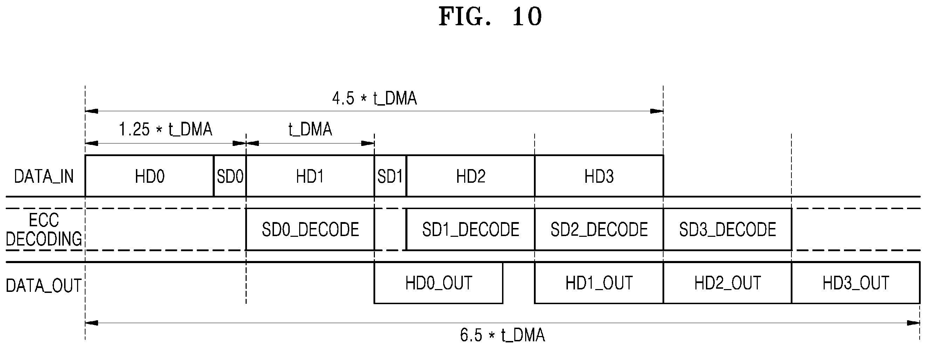

FIGS. 9 and 10 are diagrams respectively showing an example of a data formatting operation and an example of the time required for ECC decoding processing in the memory device of FIG. 7.

Referring to FIG. 9, assuming that the first to fourth soft decision data SD0 to SD3 and the first to fourth hard decision data HD0 to HD3 for one page are sequentially received from the memory device, the data formatter may receive the first to fourth soft decision data SD0 to SD3 and the first to fourth hard decision data HD0 to HD3 as data input Data_IN and provide the ECC circuit with data output Data_OUT according to the formatting result.

First, the data formatter may output the first hard decision data HD0 and the first soft decision data SD0 of the first sector to the ECC circuit, and the ECC circuit may perform soft decision decoding using the first hard decision data HD0 and the first soft decision data SD0. The ECC circuit may provide the data formatter with at least one piece of decoding information indicating the decoding result of the first hard decision data HD0 and the first soft decision data SD0, and then, the data formatter may perform the formatting operation such that soft decision data of at least one sector is not provided to the ECC circuit on the basis of the decoding information.

In an embodiment, the data formatter may provide the ECC circuit with the first and second soft decision data SD0 and SD1 for the first and second sectors among the first to fourth sectors and determine, based on the decoding information of the first and second sectors, whether to provide the ECC circuit with the third and fourth soft decision data SD2 and SD3 of the third and fourth sectors. For example, according to the embodiments described above, when the normal decoding processing using hard decision data is determined to be appropriate for both the first sector and the second sector, the formatting operation may be performed such that the third and fourth soft decision data SD2 and SD3 are not provided to the ECC circuit. Additionally, according to an embodiment, even when the normal decoding processing using hard decision data is determined to be appropriate for either the first sector or the second sector, the formatting operation may be performed such that the third and fourth soft decision data SD2 and SD3 are not provided to the ECC circuit.

According to the embodiments described above, the ECC decoding processing of one sector and the operation of providing data of the subsequent sector to the ECC circuit may be performed in parallel, and thus, it may be determined, based on the decoding information of the first sector, whether the third and fourth soft decision data SD2 and SD3 are provided to the ECC circuit. In other words, the ECC circuit may provide decoding information of the first sector to the data formatter while receiving the second hard decision data HD1 and the second soft decision data SD1 of the second sector. In this case, the data formatter may perform the formatting operation such that the third and fourth soft decision data SD2 and SD3 are not provided to the ECC circuit, based on the decoding information of the first sector.

FIG. 10 is a diagram illustrating the time required for an ECC decoding operation for one page in the memory device of the embodiment shown in FIG. 7.

Referring to FIG. 10, the first and second hard decision data HD0 and HD1 and the first and second soft decision data SD0 and SD1 for the first and second sectors may be provided to the ECC circuit, and the time required for hard decision data of each of the first and second sectors to be provided to the ECC circuit may correspond to 1.25*t_DMA. Additionally, the soft decision data is not provided to the ECC circuit for the third and fourth sectors, and thus, the time required for the data of the first to fourth sectors on one page to be provided to the ECC circuit may correspond to 4.5*t_DMA.

The soft decision decoding is not performed on the third and fourth sectors. Accordingly, the ECC circuit may perform the normal decoding processing on the third sector when the third hard decision data HD2 is completely received. In addition, the ECC circuit may perform the normal decoding processing on the fourth sector when the fourth hard decision data HD3 is completely received. In the embodiment shown in FIG. 10, it may take time 6.5*t_DMA to output all error-corrected data of the first to fourth sectors.

According to the embodiments described above, the formatting operations are performed to exclude soft decision data from being provided to the ECC circuit for sectors or pages on which it is appropriate to perform normal decoding. As a result, this approach can prevent an unnecessary number of loops from occurring during the soft decision decoding process, and eliminate the time needed to supply some soft decision data to the ECC circuit. Therefore, the total time required for the ECC decoding processing may be reduced.

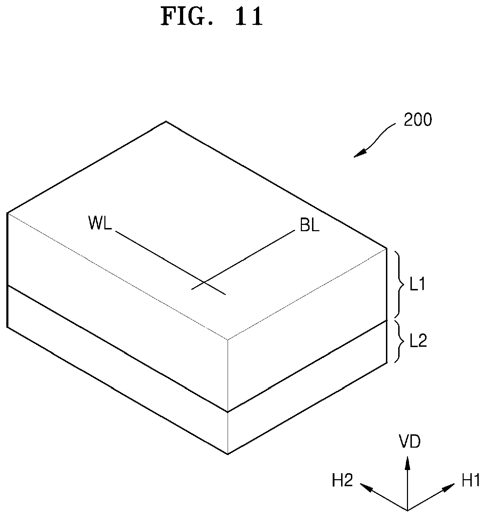

FIG. 11 is a diagram schematically showing the structure of the memory device 200 of FIG. 1, according to an embodiment.

Referring to FIGS. 1 and 11, the memory device 200 may include a first semiconductor layer L1 and a second semiconductor layer L2, and the first semiconductor layer L1 may be stacked on the second semiconductor layer L2 in a vertical direction VD. For example, the second semiconductor layer L2 may be located below the first semiconductor layer L1 in the vertical direction VD. In an embodiment, the memory cell array 210 of FIG. 1 may be formed in the first semiconductor layer L1, and a peripheral circuit that drives the memory cell array 210 may be formed in the second semiconductor layer L2. Accordingly, the memory device 200 may have a structure in which the memory cell array 210 is located above the peripheral circuit, e.g., a cell over periphery (COP) structure. The COP structure may reduce the area in the horizontal direction and improve the integration of the memory device 200.

In an embodiment, the peripheral circuit is formed in the second semiconductor layer L2, and then the first semiconductor layer L1 including the memory cell array 210 may be formed thereon. In addition, metal patterns may be formed to electrically connect word lines WL and bit lines BL of the memory cell array 210 to peripheral circuits formed in the second semiconductor layer L2. For example, the bit lines BL may extend in the first horizontal direction or a first direction H1 and the word lines WL may extend in the second horizontal direction or a second direction H2.

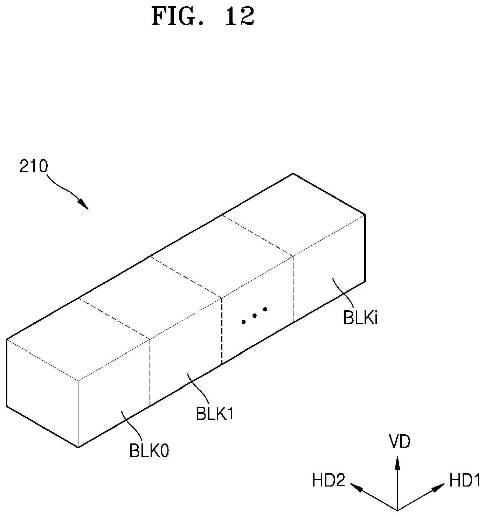

FIG. 12 is a diagram illustrating the memory cell array 210 of FIG. 1, according to an embodiment.

Referring to FIG. 12, the memory cell array 210 may include a plurality of memory blocks BLKO to BLKi, and i may be a positive integer. Each of the plurality of memory blocks BLKO to BLKi may have a 3-dimensional structure (or a vertical structure). Each of the memory blocks BLKO to BLKi may include a plurality of NAND strings extending in the vertical direction VD. Here, the plurality of NAND strings may be spaced apart from each other by a specific distance in first and second directions HD1 and HD2.

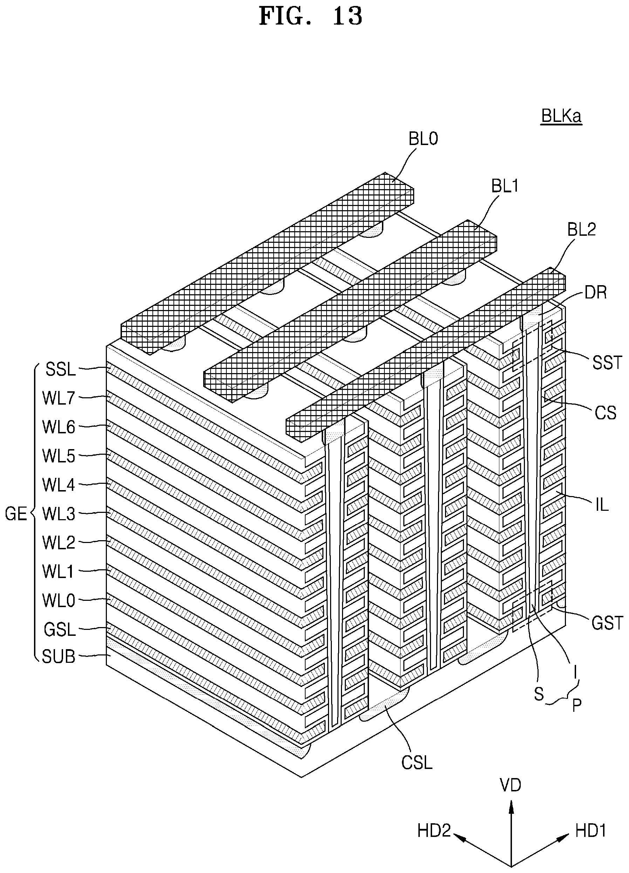

FIG. 13 is a perspective view showing a memory block BLKa according to an embodiment.

Referring to FIG. 13, the memory block BLKa may correspond to one of the plurality of memory blocks BLKO to BLKi in FIG. 12. The memory block BLKa is formed on a substrate SUB of a first conductivity type (e.g., p type) in a vertical direction VD. In an embodiment, a common source line CSL doped with impurities of a second conductivity type (e.g., n type) may be provided on the substrate SUB. In an embodiment, the substrate SUB may include polysilicon, and the common source line CSL having a plate shape may be disposed on the substrate SUB. A plurality of insulating films IL extending in a second direction HD2 are sequentially provided above the substrate SUB in the vertical direction VD, and the plurality of insulating films IL are spaced apart from each other by a specific distance in the vertical direction VD. For example, the plurality of insulating films IL may include an insulating material, such as silicon oxide.

A plurality of pillars P are sequentially arranged on the substrate SUB in a first direction HD1 and pass through the plurality of insulating films IL in the vertical direction VD. For example, the plurality of pillars P may pass through the plurality of insulating films IL and come into contact with the substrate SUB. For example, a surface layer S of each of the pillars P may include a silicon material of first type and may function as a channel region. Accordingly, the pillar P may be referred to as a vertical channel structure. Additionally, an inner layer I of each of the pillars P may include an insulating material, such as silicon oxide and an air gap.

A charge storage layer CS is provided along exposed surfaces of the insulating films IL, the pillars P, and the substrate SUB. The charge storage layer CS may include a gate insulating layer, a charge trap layer, and a blocking insulating layer. For example, the charge storage layer CS may have an oxide-nitride-oxide (ONO) structure. In addition, a gate electrode GE, which includes a ground selection line GSL, a string selection line SSL, and word lines WL0, WL1, WL2, WL3, WL4, WL5, WL6 and WL7, are provided on the exposed surface of the charge storage layer CS. A drain DR is provided on each of the plurality of pillars P. For example, the drain DR may include a silicon material doped with impurities of second conductivity type. Bit lines BL1, B12 and BL3 are provided on the drains DR, and the bit lines BL1 to BL3 extend in the first direction HD1 and are spaced apart from each other by a specific distance in the second direction HD2.

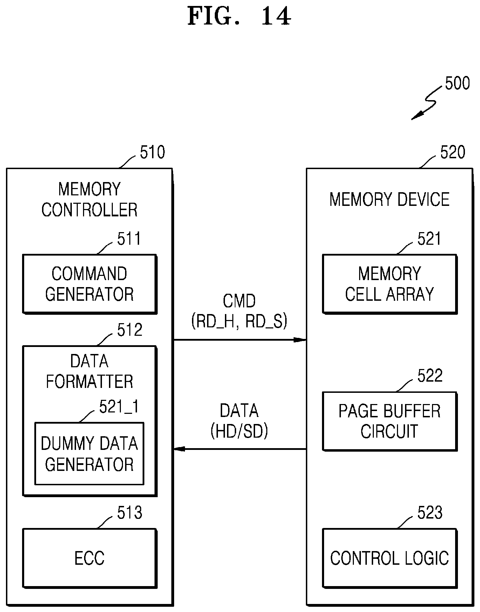

FIG. 14 is a block diagram showing a memory system 500 according to another embodiment.

Referring to FIG. 14, the memory system 500 may include a memory controller 510 and a memory device 520. The memory device 520 may include a memory cell array 521, a page buffer circuit 522, and a control logic 523. The memory controller 510 may include a command generator 511, a data formatter 512, and an ECC circuit 513, and the data formatter 512 may include a dummy data generator 512_1.

The command generator 511 may generate various types of commands CMD, for example, a read command to read data. Additionally, in the embodiment, the memory device 520 may determine the order in which hard decision data and soft decision data are output, according to the command provided from the command generator 511. If a first read command RD_H is provided, based on a control of the control logic 523, the memory device 520 may output hard decision data HD first. If a second read command RD_S is provided, the memory device 520 may output soft decision data SD first. The data formatter 512 receives hard decision data and soft decision data from the memory device 520 and provides the hard decision data and soft decision data to the ECC circuit 513. The ECC circuit 513 may include a buffer having a size sufficient to store the hard decision data and/or soft decision data.

In an embodiment, one page includes a plurality of sectors (e.g., four). In each of the sectors, the hard decision data may have a size of 4 KB and the soft decision data may have a size of 1 KB depending on the compression used. In addition, the memory controller 510 may internally transmit data based on the size of a unit. For example, data may be transmitted to the data formatter 512 and the ECC circuit 513 in units of 4 KB in size or data may be transmitted to the data formatter 512 and the ECC circuit 513 in units of 1 KB in size. In addition, the data transmission sizes inside the memory controller 510 may correspond to the data read sizes of the memory controller 510 and the memory device 520. The memory controller 510 may perform internal data transmission with a size corresponding to a read unit for the memory device 520. The embodiments are not necessarily limited to the 4 KB or 1 KB sizes described above, and the memory controller 510 may transmit data in units of various sizes.

In the embodiment shown in FIG. 14, the data formatter 512 may continuously provide the hard decision data HD and the soft decision data SD to the ECC circuit 513 for each of the sectors. In providing the soft decision data SD in a read environment of 4 KB, the data formatter 512 may add dummy data of 3 KB to one soft decision data SD of 1 KB and provide the data to the ECC circuit 513. In other words, to transmit data having a size corresponding to the read environment, the ECC circuit may be supplied with the dummy data and the soft decision data for a sector in which the soft decision decoding is to be actually performed, instead of providing a plurality of pieces of soft decision data to the ECC circuit.

According to the embodiment described above, in read environments of varying sizes, the hard decision data and soft decision data for the sector where the ECC decoding processing is to be actually performed may be continuously provided to the ECC circuit. Accordingly, the speed of ECC decoding processing may be improved. For example, during the ECC decoding processing for a sector at a specific location, the transmission of the sector's soft decision data to the ECC circuit is not delayed by a communication constraint, such as that due to a 4 KB unit size. Therefore, it is possible to reduce the time required for ECC decoding processing on all sectors of one page.

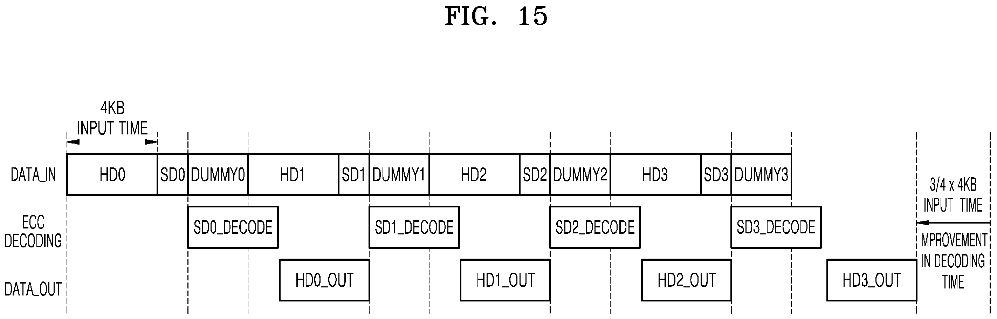

FIGS. 15 to 17 are diagrams showing examples of ECC decoding processing and times required for the ECC decoding processing, according to some embodiments.

Referring to FIG. 15, a memory controller may receive first to fourth hard decision data HD0 to HD3 and first to fourth soft decision data SD0 to SD3 from a memory device. Each of the pieces of the hard decision data may have a size of 4 KB and each of the pieces of the soft decision data may have a size of 1 KB. Assuming a read environment of 4 KB in size, the memory controller may continuously provide hard decision data and soft decision data for each of sectors to the ECC circuit, by performing formatting operations on the first to fourth hard decision data HD0 to HD3 and the first to fourth soft decision data SD0 to SD3. Here, in providing 1 KB of soft decision data in response to a 4 KB read environment, 1 KB of soft decision data and 3 KB of dummy data may be continuously provided to the ECC circuit.

For example, the memory controller may sequentially provide first hard decision data HD0, first soft decision data SD0, and first dummy data Dummy0 to the ECC circuit on the basis of the formatting operation. The ECC circuit may perform soft decision decoding on a first sector when the first soft decision data SD0 is completely received, irrespective of receiving the first dummy data Dummy0. For example, the soft decision decoding on the first sector may be performed while the first dummy data Dummy0 is being received.

Similarly, the soft decision decoding for second to fourth sectors may also be performed in the same manner described above. For example, second dummy data Dummy1 may be provided to the ECC circuit in succession to the second soft decision data SD1, and the ECC circuit may perform the soft decision decoding on the second sector when the second soft decision data SD1 is completely received. In addition, third dummy data Dummy2 may be provided to the ECC circuit in succession to the third soft decision data SD2 and fourth dummy data Dummy3 may be provided to the ECC circuit in succession to the fourth soft decision data SD3. In both of these cases, the soft decision decoding may be performed while the dummy data is received. According to the method described above, the time required for ECC decoding processing may be reduced by the time corresponding to a data input time of 3/4*4 KB, compared to the case in which soft decision data from a plurality of sectors are provided to the ECC circuit during the soft decision decoding process for one sector.

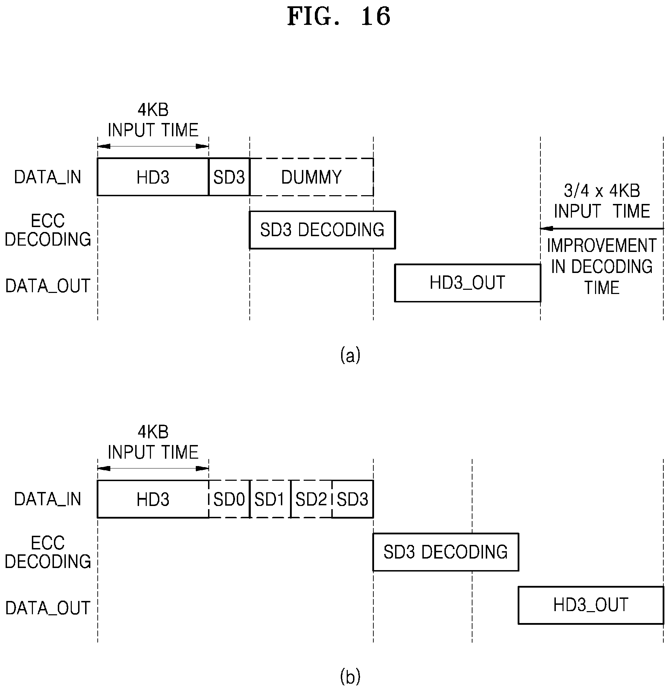

Diagram (a) of FIG. 16 illustrates a case in which a memory controller performs a random read of 4 KB in size on a memory device. For example, the case is described, in which a fourth sector among first to fourth sectors belonging to one page is selectively read. In response to a read command from the memory controller, the memory device may output, to the memory controller, fourth hard decision data HD3 of the fourth sector corresponding to 4 KB and first to fourth soft decision data SD0 to SD3 of the first to fourth sectors corresponding to 4 KB.

On the basis of the formatting operation described above, the memory controller may provide the ECC circuit with the fourth soft decision data SD3 among the first to fourth soft decision data SD0 to SD3 and provide the ECC circuit with dummy data Dummy of 3 KB in size in succession to the fourth soft decision data SD3. Additionally, the ECC circuit may perform soft decision decoding on the fourth sector when the fourth soft decision data SD3 is completely received.

On the other hand, in diagram (b) of FIG. 16, there is show a case to which the embodiment is not applied. Here, an ECC circuit may receive fourth hard decision data HD3 and first to fourth soft decision data SD0 to SD3 provided from a memory device and perform soft decision decoding on a fourth sector when the first to fourth soft decision data SD0 to SD3 are completely received. In other words, when the embodiment is applied, the time required for ECC decoding processing may be reduced by the time corresponding to 3/4*4 KB, compared to the case shown in (b) of FIG. 16.

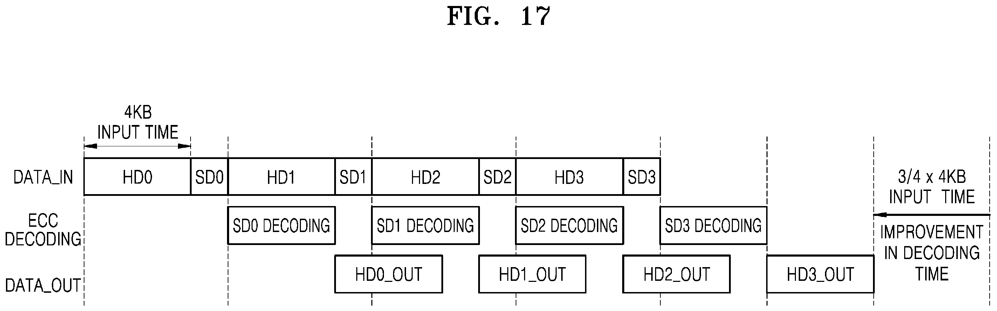

FIG. 17 is a diagram showing a case to which the embodiments are applied in a read environment of 1 KB in size. In an embodiment, a memory controller may perform a read operation on a memory device in units of 1 KB. Additionally, the memory controller may transfer data between internal components (e.g., a data formatter and an ECC circuit) in units of 1 KB.

As in an embodiment shown in FIG. 17, the memory controller may continuously provide hard decision data and soft decision data for each sector to the ECC circuit on the basis of the formatting operation. In addition, when performing soft decision decoding on each sector, the ECC circuit may perform soft decision decoding when the soft decision data of the corresponding sector is completely received. For example, as shown in FIG. 17, the ECC circuit may receive first hard decision data HD0 and first soft decision data SD0 and perform soft decision decoding. In addition, while the ECC circuit performs soft decision decoding on a first sector, the ECC circuit may receive second hard decision data HD1 for a second sector in parallel to the soft decision decoding on the first sector. In other words, the second hard decision data HD1 may be received while the soft decision decoding is performed on the first sector. When performing ECC decoding processing on sectors of one page by the processes described above, the time required for the ECC decoding processing may be further reduced by the time corresponding to 3*4 KB, compared to the embodiment shown in diagram (a) of FIG. 16.

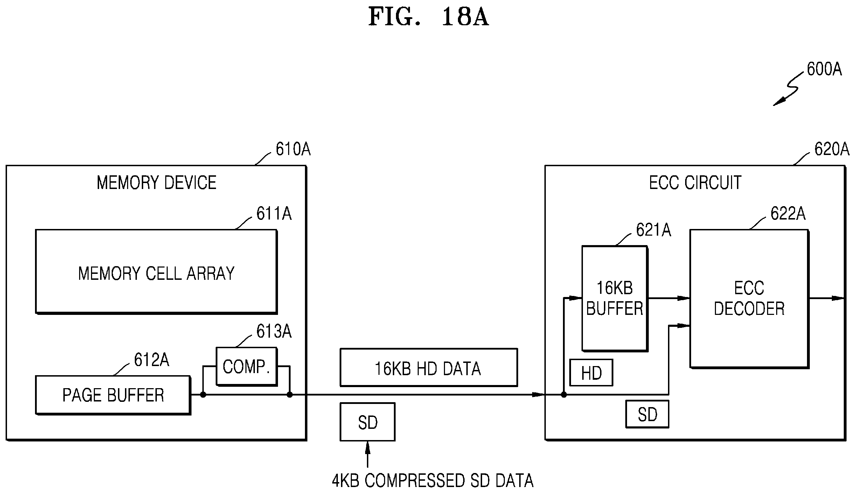

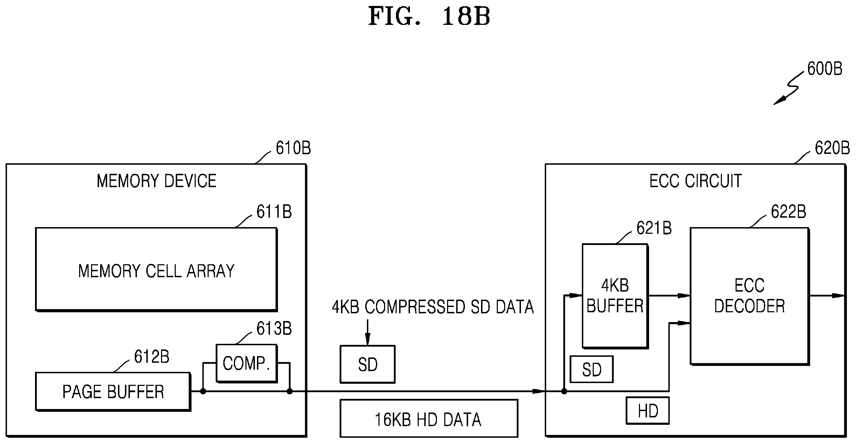

FIGS. 18A and 18B show examples of memory systems 600A and 600B, respectively, according to embodiments. In FIGS. 18A and 18B, only an ECC circuit is shown in relation to the configuration of a memory controller, but various other components according to the above-described embodiments may be further provided in memory controllers of FIGS. 18A and 18B.

The memory system 600A may include a memory device 610A and an ECC circuit 620A, and the memory device 610A may include a memory cell array 611A, a page buffer circuit 612A, and a compressor 613A. The ECC circuit 620A may include a buffer 621A and an ECC decoder 622A.

The memory device 610A may output page data in response to a command from the memory controller. Assuming that one page includes four sectors and each sector includes data of 4 KB in size, the memory device 610A may output hard decision data HD of 16 KB in size (16KB HD data) and soft decision data SD of 4 KB in size (4KB compressed SD data). Assuming that the hard decision data HD is output first from the memory device 610A, the buffer 621A may have a size of 16 KB for storing the hard decision data HD of four sectors. Subsequently, the soft decision data SD for the first to fourth sectors may be sequentially provided to the ECC decoder 622A. While the first soft decision data of the first sector is provided to the ECC decoder 622A, the first hard decision data of the first sector stored in the buffer 621A may be provided together to the ECC decoder 622A. Accordingly, the ECC decoder 622A may perform soft decision decoding on the first sector. Similarly, in response to the soft decision data of the remaining second to fourth sectors being sequentially provided to the ECC decoder 622A, the hard decision data of the second to fourth sectors stored in the buffer 621A are provided to the ECC decoder 622A. Accordingly, the ECC decoder 622A may perform soft decision decoding on the second to fourth sectors.

Referring to FIG. 18B, the memory system 600B may include a memory device 610B and an ECC circuit 620B, and the memory device 610B may include a memory cell array 611B, a page buffer circuit 612B, and a compressor 613B. The ECC circuit 620B may include a buffer 621B and an ECC decoder 622B. FIG. 18B illustrates a case in which the memory device 610B outputs soft decision data SD of 4 KB in size (4KB compressed SD data) and then outputs hard decision data HD of 16 KB in size (16KB HD data).

In the embodiment shown in FIG. 18B, the buffer 621B stores the soft decision data SD and may thus have a size of 4 KB. While the first hard decision data of the first sector is provided to the ECC decoder 622B, the first soft decision data of the first sector stored in the buffer 621B may be provided together to the ECC decoder 622B. Accordingly, the ECC decoder 622B may perform soft decision decoding on the first sector. According to the above process, soft decision decoding may be sequentially performed on the remaining second to fourth sectors.

According to the above embodiments, the buffer in the ECC circuit may selectively store only hard decision data or soft decision data, without needing to have a relatively large size to store both the hard decision data and the soft decision data. Accordingly, the size of the buffer may be reduced. In addition, in order for the memory system to support various output modes, the ECC circuit may include a buffer of 16 KB in size as shown in FIG. 18A. In addition, the memory system may be configured such that a single buffer in the ECC circuit is used to store 16 KB of hard decision data or 4 KB of soft decision data depending on the output mode.

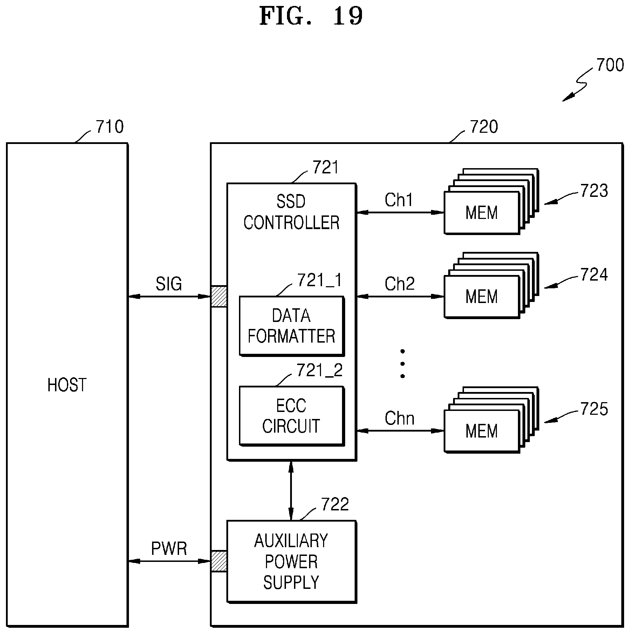

FIG. 19 is a block diagram showing an example in which memory devices according to embodiments are applied to an SSD system 700.

Referring to FIG. 19, the SSD system 700 may include a host 710 and an SSD 720. The SSD 720 exchanges signals (SIG) with the host 710 via a signal connector and receives power (PWR) via a power connector. The SSD 720 may include an SSD controller 721, an auxiliary power supply 722, and memory devices 723, 724 and 725. The memory devices 723 to 725 may include vertically stacked NAND flash memory devices. The memory devices 723 to 725 may be connected to the SSD controller 721 via a plurality of channels Ch1, Ch2 ... Chn. Here, the SSD 720 may be embodied using the embodiments described above with reference to FIGS. 1 to 19.

For example, the SSD controller 721 may correspond to the memory controller described in the above embodiments and the memory devices 723 to 725 may correspond to the memory devices according to the above embodiments. The hard decision data and the soft decision data may be transmitted and received between the SSD controller 721 and the memory devices 723 to 725. The SSD controller 721 includes a data formatter 721_1 and an ECC circuit 721_2. The data formatter 721_1 performs a formatting operation on hard decision data and soft decision data provided from the memory devices 723 to 725 and thus provide the ECC circuit 721_2 with data having a format optimized for ECC decoding processing. The data formatter 721_1 performs a formatting operation to change the order of data provided from the memory devices 723 to 725 and thus provide the ECC circuit 721_2 with hard decision data and soft decision data of a plurality of sectors in the changed order.

While the inventive concept has been particularly shown and described with reference to embodiments thereof, it will be understood that various changes in form and detail may be made thereto without departing from the scope of the inventive concept as set forth in the following claims.

## Claims

1. A memory controller (100; 300; 510; 721) comprising:
a data formatter (130; 310; 300A; 300B; 512; 721_1) configured to receive first to N-th hard decision data (HD; HD0 to HD3) read based on a normal read level and first to N-th soft decision data (SD; SD0 to SD3) read based on an offset read level (Offset 1; Offset 2), for first to N-th sectors on a first page of a memory device (200; 520; 610A; 610B; 723; 724; 725), and perform a formatting operation on the first to N-th hard decision data (HD; HD0 to HD3) and the first to N-th soft decision data (SD; SD0 to SD3), where N is an integer of 2 or more; and
an error correction code, ECC, circuit (120; 320; 513; 721_2) configured to receive the first to N-th hard decision data (HD; HD0 to HD3) and the first to N-th soft decision data (SD; SD0 to SD3) from the data formatter (130; 310; 300A; 300B; 512; 721_1) and correct an error on the first page by ECC decoding processing,
the memory controller being **characterised in that** the data formatter (130; 310; 300A; 300B; 512; 721_1) is configured to perform the formatting operation such that the first to N-th hard decision data (HD; HD0 to HD3) and the first to N-th soft decision data (SD; SD0 to SD3) are provided to the ECC circuit (120; 320; 513; 721_2) in an order different from an order of the first to N-th hard decision data (HD; HD0 to HD3) and the first to N-th soft decision data (SD; SD0 to SD3) were received from the memory device (200; 520; 610A; 610B; 723; 724; 725).

2. The memory controller (100; 300; 510; 721) of claim 1, wherein the first to N-th soft decision data (SD; SD0 to SD3) have been compressed in the memory device (200; 520; 610A; 610B; 723; 724; 725) and provided to the memory controller (100; 300; 510; 721), such that each of the first to N-th soft decision data (SD; SD0 to SD3) has a smaller size than its corresponding first to N-th hard decision data (HD; HD0 to HD3).

3. The memory controller (100; 300; 510; 721) of claim 2, wherein the memory controller (100; 300; 510; 721) is configured such that the hard decision data (HD; HD0 to HD3) and soft decision data (SD; SD0 to SD3) of each of the first to N-th sectors are continuously provided to the ECC circuit (120; 320; 513; 721_2) from the data formatter (130; 310; 300A; 300B; 512; 721_1).

4. The memory controller (100; 300; 510; 721) of claim 2, wherein the memory controller (100; 300; 510; 721) is configured such that the first to N-th hard decision data (HD; HD0 to HD3) are provided to the ECC circuit (120; 320; 513; 721_2) from the data formatter (130; 310; 300A; 300B; 512; 721_1) after the first to N-th soft decision data (SD; SD0 to SD3) are provided to the ECC circuit (120; 320; 513; 721_2) from the data formatter (130; 310; 300A; 300B; 512; 721_1).

5. The memory controller (100; 300; 510; 721) of claim 2, wherein, to perform normal decoding processing using the hard decision data (HD; HD0 to HD3) on at least one of the first to N-th sectors on the first page, the data formatter (130; 310; 300A; 300B; 512; 721_1) is configured to perform the formatting operation such that the soft decision data (SD; SD0 to SD3) corresponding to the at least one sector is not provided to the ECC circuit (120; 320; 513; 721_2).

6. The memory controller (100; 300; 510; 721) of claim 1, wherein the data formatter (130; 310; 300A; 300B; 512; 721_1) is configured to
receive the first to N-th soft decision data (SD; SD0 to SD3) after receiving the first to N-th hard decision data (HD; HD0 to HD3) and
perform the formatting operation such that the soft decision data (SD; SD0 to SD3) of one of the first to N-th sectors is provided to the ECC circuit (120; 320; 513; 721_2) before the hard decision data (HD; HD0 to HD3) of another one of the first to N-th sectors is provided to the ECC circuit (120; 320; 513; 721_2).

7. The memory controller (100; 300; 510; 721) of claim 1, wherein the data formatter (130; 310; 300A; 300B; 512; 721_1) is configured to
receive at least one piece of decoding information based on a result of the ECC decoding processing and
perform, based on the decoding information, the formatting operation such that the soft decision data (SD; SD0 to SD3) of some of the first to N-th sectors is not provided to the ECC circuit (120; 320; 513; 721_2).

8. The memory controller (100; 300; 510; 721) of claim 7, wherein the memory controller (100; 300; 510; 721) is configured such that, when the number of errors occurring in one sector on which the ECC decoding processing has been performed first among the first to N-th sectors is less than a reference value, the formatting operation is performed such that the soft decision data (SD; SD0 to SD3) of another of the first to N-th sectors is not provided to the ECC circuit (120; 320; 513; 721_2).

9. The memory controller (100; 300; 510; 721) of claim 7, wherein the memory controller (100; 300; 510; 721) is configured such that, when the number of loop executions in the ECC decoding processing using the soft decision data (SD; SD0 to SD3) of one of the first to N-th sectors exceeds a threshold, the formatting operation is performed such that the soft decision data (SD; SD0 to SD3) of another of the first to N-th sectors is not provided to the ECC circuit (120; 320; 513; 721_2).

10. The memory controller (100; 300; 510; 721) of claim 1, wherein the data formatter (130; 310; 300A; 300B; 512; 721_1) is configured to
receive first to N-th hard decision data (HD; HD0 to HD3) and first to N-th soft decision data (SD; SD0 to SD3) for first to N-th sectors on a second page of the memory device (200; 520; 610A; 610B; 723; 724; 725) and
perform the formatting operation such that the hard decision data (HD; HD0 to HD3), the soft decision data (SD; SD0 to SD3), and dummy data of any one of the first to N-th sectors on the second page are continuously provided to the ECC circuit (120; 320; 513; 721_2),
wherein each of the first to N-th soft decision data (SD; SD0 to SD3) has been compressed in the memory device (200; 520; 610A; 610B; 723; 724; 725) and has a smaller size than its corresponding first to N-th hard decision data (HD; HD0 to HD3), and
wherein a sum of the size of the soft decision data (SD; SD0 to SD3) and a size of the dummy data of any one sector of the first to N-th sectors on the second page is equal to the size of the hard decision data (HD; HD0 to HD3) of that sector.

11. The memory controller (100; 300; 510; 721) of claim 2, wherein the data formatter (130; 310; 300A; 300B; 512; 721_1) is configured to
continuously provide the first hard decision data (HDO) and the first soft decision data (SDO) of the first sector to the ECC circuit (120; 320; 513; 721_2) and
perform the formatting operation such that first dummy data (Dummy0) is provided to the ECC circuit (120; 320; 513; 721_2) in succession to the first soft decision data (SD0).

12. The memory controller (100; 300; 510; 721) of claim 11, wherein the size of the first hard decision data (HDO) is equal to a sum of the size of the first soft decision data (SDO) and a size of the first dummy data (Dummy0).

13. The memory controller (100; 300; 510; 721) of claim 11, wherein the ECC circuit (120; 320; 513; 721_2) is configured to perform the ECC decoding processing on the first sector when the first soft decision data (SDO) is completely received.

14. The memory controller (100; 300; 510; 721) of claim 11, wherein:
the data formatter (130; 310; 300A; 300B; 512; 721_1) is configured to continuously provide second hard decision data (HD1), second soft decision data (SD1), and second dummy data (Dummy1) of a second sector to the ECC circuit (120; 320; 513; 721_2) after outputting the first dummy data (Dummy0), and
the ECC circuit (120; 320; 513; 721_2) is configured to perform the ECC decoding processing on the second sector when the second soft decision data (SD1) is completely received.

15. The memory controller (100; 300; 510; 721) of claim 11, wherein:
the memory controller (100; 300; 510; 721) is configured to output, to the memory device (200; 520; 610A; 610B; 723; 724; 725), a read command to read a K-th sector among the first to N-th sectors on a second page of the memory device (200; 520; 610A; 610B; 723; 724; 725) and to receive, from the memory device (200; 520; 610A; 610B; 723; 724; 725), K-th hard decision data of the K-th sector and the first to N-th soft decision data of the first to N-th sectors, where K is an integer of 1 to N,
the data formatter (130; 310; 300A; 300B; 512; 721_1) is configured to provide the K-th soft decision data among the received first to N-th soft decision data (SD; SD0 to SD3) to the ECC circuit (120; 320; 513; 721_2) and to provide K-th dummy data to the ECC circuit (120; 320; 513; 721_2) in succession to the K-th soft decision data (SD; SD0 to SD3), and
the ECC circuit (120; 320; 513; 721_2) is configured to perform the ECC decoding processing on the K-th sector when the K-th soft decision data is completely received.

## Patentansprüche

1. Ein Speichercontroller (100; 300; 510; 721), umfassend:
einen Datenformatierer (130; 310; 300A; 300B; 512; 721_1), welcher derart konfiguriert ist, dass er erste bis N-te Hard-Decision-Daten (HD; HD0 bis HD3), welche auf der Grundlage eines normalen Lesepegels gelesen werden, und erste bis N-te Soft-Decision-Daten (SD; SD0 bis SD3), welche auf der Grundlage eines Offset-Lesepegels (Offset 1; Offset 2) gelesen werden, für erste bis N-te Sektoren auf einer ersten Seite einer Speichervorrichtung (200; 520; 610A; 610B; 723; 724; 725) empfängt, und einen Formatierungsvorgang für die ersten bis N-ten Hard-Decision-Daten (HD; HD0 bis HD3) und die ersten bis N-ten Soft-Decision-Daten (SD; SD0 bis SD3), wobei N eine ganze Zahl von 2 oder mehr ist, durchführt; und
eine Fehlerkorrekturcode-ECC-Schaltung (120; 320; 513; 721_2), welche derart konfiguriert ist, dass sie die ersten bis N-ten Hard-Decision-Daten (HD; HD0 bis HD3) und die ersten bis N-ten Soft-Decision-Daten (SD; SD0 bis SD3) von dem Datenformatierer (130; 310; 300A; 300B; 512; 721_1) empfängt und einen Fehler auf der ersten Seite durch ECC-Decodierungsverarbeitung korrigiert, wobei der Speichercontroller **dadurch gekennzeichnet ist, dass**
der Datenformatierer (130; 310; 300A; 300B; 512; 721_1) derart konfiguriert ist, dass er den Formatierungsvorgang derart ausführt, dass die ersten bis N-ten Hard-Decision-Daten (HD; HD0 bis HD3) und die ersten bis N-ten Soft-Decision-Daten (SD; SD0 bis SD3) der ECC-Schaltung (120; 320; 513; 721_2) in einer Reihenfolge bereitgestellt werden, welche sich von der Reihenfolge der ersten bis N-ten Hard-Decision-Daten (HD; HD0 bis HD3) und der ersten bis N-ten Soft-Decision-Daten (SD; SD0 bis SD3) unterscheidet, welche von der Speichervorrichtung (200; 520; 610A; 610B; 723; 724; 725) empfangen wurden.

2. Der Speichercontroller (100; 300; 510; 721) nach Anspruch 1, wobei die ersten bis N-ten Soft-Decision-Daten (SD; SD0 bis SD3) in der Speichervorrichtung (200; 520; 610A; 610B; 723; 724; 725) komprimiert und dem Speichercontroller (100; 300; 510; 721) derart bereitgestellt worden sind, dass jedes der ersten bis N-ten Soft-Decision-Daten (SD; SD0 bis SD3) eine kleinere Größe als die entsprechenden ersten bis N-ten Hard-Decision-Daten (HD; HD0 bis HD3) aufweist.

3. Der Speichercontroller (100; 300; 510; 721) nach Anspruch 2, wobei der Speichercontroller (100; 300; 510; 721) derart konfiguriert ist, dass die Hard-Decision-Daten (HD; HD0 bis HD3) und Soft-Decision-Daten (SD; SD0 bis SD3) jedes der ersten bis N-ten Sektoren kontinuierlich an die ECC-Schaltung (120; 320; 513; 721_2) von dem Datenformatierer (130; 310; 300A; 300B; 512; 721_1) bereitgestellt werden.

4. Der Speichercontroller (100; 300; 510; 721) nach Anspruch 2, wobei der Speichercontroller (100; 300; 510; 721) derart konfiguriert ist, dass die ersten bis N-ten Hard-Decision-Daten (HD; HD0 bis HD3) der ECC-Schaltung (120; 320; 513; 721_2) aus dem Datenformatierer (130; 310; 300A; 300B; 512; 721_1) bereitgestellt werden, nachdem die ersten bis N-ten Soft-Decision-Daten (SD; SD0 bis SD3) der ECC-Schaltung (120; 320; 513; 721_2) von dem Datenformatierer (130; 310; 300A; 300B; 512; 721_1) bereitgestellt werden.

5. Der Speichercontroller (100; 300; 510; 721) nach Anspruch 2, wobei, um eine normale Decodierungsverarbeitung unter Verwendung der Hard-Decision-Daten (HD; HD0 bis HD3) auf mindestens einem der ersten bis N-ten Sektoren auf der ersten Seite durchzuführen, der Datenformatierer (130; 310; 300A; 300B; 512; 721_1) derart konfiguriert ist, dass er den Formatierungsvorgang derart ausführt, dass die Soft-Decision-Daten (SD; SD0 bis SD3), welche dem mindestens einen Sektor entsprechen, nicht an die ECC-Schaltung (120; 320; 513; 721_2) geliefert werden.

6. Der Speichercontroller (100; 300; 510; 721) nach Anspruch 1, wobei der Datenformatierer (130; 310; 300A; 300B; 512; 721_1) derart konfiguriert ist, dass er
die ersten bis N-ten Soft-Decision-Daten (SD; SD0 bis SD3) nach dem Empfang der ersten bis N-ten Hard-Decision-Daten (HD; HD0 bis HD3) empfängt, und
den Formatierungsvorgang derart durchführt, dass die Soft-Decision-Daten (SD; SD0 bis SD3) eines der ersten bis N-ten Sektoren der ECC-Schaltung (120; 320; 513; 721_2) bereitgestellt werden, bevor die Hard-Decision-Daten (HD; HD0 bis HD3) eines anderen der ersten bis N-ten Sektoren der ECC-Schaltung (120; 320; 513; 721_2) bereitgestellt werden.

7. Der Speichercontroller (100; 300; 510; 721) nach Anspruch 1, wobei der Datenformatierer (130; 310; 300A; 300B; 512; 721_1) derart konfiguriert ist, dass er mindestens einen Teil der Dekodierungsinformation basierend auf einem Ergebnis der ECC-Dekodierungsverarbeitung empfängt, und
basierend auf der Dekodierungsinformation den Formatierungsvorgang derart durchführt, dass die Soft-Decision-Daten (SD; SD0 bis SD3) einiger der ersten bis N-ten Sektoren nicht an die ECC-Schaltung (120; 320; 513; 721_2) bereitgestellt werden.

8. Der Speichercontroller (100; 300; 510; 721) nach Anspruch 7, wobei der Speichercontroller (100; 300; 510; 721) derart konfiguriert ist, dass, wenn die Anzahl der Fehler, die in einem Sektor auftreten, auf den die ECC-Decodierungsverarbeitung zuerst unter den ersten bis N-ten Sektoren angewendet wurde, kleiner als ein Referenzwert ist, der Formatierungsvorgang derart durchgeführt wird, dass die Soft-Decision-Daten (SD; SD0 bis SD3) eines anderen der ersten bis N-ten Sektoren nicht an die ECC-Schaltung (120; 320; 513; 721_2) bereitgestellt werden.

9. Der Speichercontroller (100; 300; 510; 721) nach Anspruch 7, wobei der Speichercontroller (100; 300; 510; 721) derart konfiguriert ist, dass, wenn die Anzahl der Schleifenausführungen in der ECC-Decodierungsverarbeitung unter Verwendung der Soft-Decision-Daten (SD; SD0 bis SD3) eines der ersten bis N-ten Sektoren einen Schwellenwert überschreitet, der Formatierungsvorgang derart durchgeführt wird, dass die Soft-Decision-Daten (SD; SD0 bis SD3) eines anderen der ersten bis N-ten Sektoren nicht an die ECC-Schaltung (120; 320; 513; 721_2) geliefert werden.

10. Der Speichercontroller (100; 300; 510; 721) nach Anspruch 1, wobei der Datenformatierer (130; 310; 300A; 300B; 512; 721_1) derart konfiguriert ist, dass er
erste bis N-te Hard-Decision-Daten (HD; HD0 bis HD3) und erste bis N-te Soft-Decision-Daten (SD; SD0 bis SD3) für erste bis N-te Sektoren auf einer zweiten Seite der Speichervorrichtung (200; 520; 610A; 610B; 723; 724; 725) empfängt, und
der Formatierungsvorgang derart ausgeführt wird, dass die Hard-Decision-Daten (HD; HD0 bis HD3), die Soft-Decision-Daten (SD; SD0 bis SD3) und Dummy-Daten eines beliebigen der ersten bis N-ten Sektoren auf der zweiten Seite kontinuierlich an die ECC-Schaltung (120; 320; 513; 721_2) bereitgestellt werden,
wobei jede der ersten bis N-ten Soft-Decision-Daten (SD; SD0 bis SD3) in der Speichervorrichtung (200; 520; 610A; 610B; 723; 724; 725) komprimiert wurde und eine kleinere Größe als die entsprechenden ersten bis N-ten Hard-Decision-Daten (HD; HD0 bis HD3), und
wobei die Summe aus der Größe der Soft-Decision-Daten (SD; SD0 bis SD3) und einer Größe der Dummy-Daten eines beliebigen Sektors des ersten bis N-ten Sektors auf der zweiten Seite gleich der Größe Hard-Decision-Daten (HD; HD0 bis HD3) dieses Sektors ist.

11. Der Speichercontroller (100; 300; 510; 721) nach Anspruch 2, wobei der Datenformatierer (130; 310; 300A; 300B; 512; 721_1) derart konfiguriert ist, dass er
die ersten Hard-Decision-Daten (HDO) und die ersten Soft-Decision-Daten (SDO) des ersten Sektors kontinuierlich an die ECC-Schaltung (120; 320; 513; 721_2) liefert, und
der Formatierungsvorgang derart durchgeführt wird, dass erste Dummy-Daten (Dummy0) nacheinander mit den ersten Soft-Decision-Daten (SDO) an die ECC-Schaltung (120; 320; 513; 721_2) geliefert werden.

12. Der Speichercontroller (100; 300; 510; 721) nach Anspruch 11, wobei die Größe der ersten Hard-Decision-Daten (HDO) gleich der Summe aus der Größe der ersten Soft-Decision-Daten (SDO) und einer Größe der ersten Dummy-Daten (Dummy0) ist.

13. Der Speichercontroller (100; 300; 510; 721) gemäß Anspruch 11, wobei die ECC-Schaltung (120; 320; 513; 721_2) derart konfiguriert ist, dass sie die ECC-Decodierungsverarbeitung für den ersten Sektor durchführt, wenn die ersten Soft-Decision-Daten (SDO) vollständig empfangen wurden.

14. Der Speichercontroller (100; 300; 510; 721) nach Anspruch 11, wobei:
der Datenformatierer (130; 310; 300A; 300B; 512; 721_1) derart konfiguriert ist, dass er kontinuierlich zweite Hard-Decision-Daten (HD1), zweite Soft-Decision-Daten (SD1) und zweite Dummy-Daten (Dummy1) eines zweiten Sektors an die ECC-Schaltung (120; 320; 513; 721_2) liefert, nachdem die ersten Dummy-Daten (Dummy0) ausgegeben wurden, und
die ECC-Schaltung (120; 320; 513; 721_2) derart konfiguriert ist, dass sie die ECC-Decodierungsverarbeitung für den zweiten Sektor durchführt, wenn die zweiten Soft-Decision-Daten (SD1) vollständig empfangen wurden.

15. Der Speichercontroller (100; 300; 510; 721) gemäß Anspruch 11, wobei:
der Speichercontroller (100; 300; 510; 721) derart konfiguriert ist, dass er an die Speichervorrichtung (200; 520; 610A; 610B; 723; 724; 725) einen Lesebefehl zum Lesen eines K-ten Sektors unter den ersten bis N-ten Sektoren auf einer zweiten Seite der Speichervorrichtung (200; 520; 610A; 610B; 723; 724; 725) ausgibt und von der Speichervorrichtung (200; 520; 610A; 610B; 723; 724; 725) die K-ten Hard-Decision-Daten des K-ten Sektors und die ersten bis N-ten Soft-Decision-Daten der ersten bis N-ten Sektoren empfängt, wobei K eine ganze Zahl von 1 bis N ist,
der Datenformatierer (130; 310; 300A; 300B; 512; 721_1) derart konfiguriert ist, dass er die K-ten Soft-Decision-Daten unter den empfangenen ersten bis N-ten Soft-Decision-Daten (SD; SD0 bis SD3) an die ECC-Schaltung (120; 320; 513; 721_2) liefert und K-te Dummy-Daten an die ECC-Schaltung (120; 320; 513; 721_2) liefert, und
die ECC-Schaltung (120; 320; 513; 721_2) derart konfiguriert ist, dass sie die ECC-Decodierungsverarbeitung für den K-ten Sektor durchführt, wenn die K-ten Soft-Decision-Daten vollständig empfangen wurden.

## Revendications

1. Contrôleur mémoire (100; 300; 510; 721) comprenant :
un formateur de données (130; 310; 300A; 300B; 512; 721_1) configuré pour recevoir des premières à N-ièmes données de décision dure (HD; HD0 à HD3) lues sur la base d'un niveau de lecture normal et des premières à N-ièmes données de décision souple (SD; SD0 à SD3) lues sur la base d'un niveau de lecture décalé (Offset 1; Offset 2), pour des premiers à N-ièmes secteurs sur une première page d'un dispositif mémoire (200; 520; 610A; 610B; 723; 724; 725), et pour effectuer une opération de formatage sur les premières à N-ièmes données de décision dure (HD; HD0 à HD3) et les premières à N-ièmes données de décision souple (SD; SD0 à SD3), où N est un entier supérieur ou égal à 2; et
un circuit de code correcteur d'erreurs, ECC, (120; 320; 513; 721_2) configuré pour recevoir les premières à N-ièmes données de décision dure (HD; HD0 à HD3) et les premières à N-ièmes données de décision souple (SD; SD0 à SD3) à partir du formateur de données (130; 310; 300A; 300B; 512; 721_1) et corriger une erreur sur la première page par traitement de décodage ECC,
le contrôleur mémoire étant **caractérisé en ce que**
le formateur de données (130; 310; 300A; 300B; 512; 721_1) est configuré pour effectuer l'opération de formatage de telle sorte que les premières à N-ièmes données de décision dure (HD; HD0 à HD3) et les premières à N-ièmes données de décision souple (SD; SD0 à SD3) soient fournies au circuit ECC (120; 320; 513; 721_2) dans un ordre différent de l'ordre dans lequel les premières à N-ièmes données de décision dure (HD; HD0 à HD3) et les premières à N-ièmes données de décision souple (SD; SD0 à SD3) ont été reçues à partir du dispositif mémoire (200; 520; 610A; 610B; 723; 724; 725).

2. Contrôleur mémoire (100; 300; 510; 721) selon la revendication 1, dans lequel les premières à N-ièmes données de décision souple (SD; SD0 à SD3) ont été compressées dans le dispositif mémoire (200; 520; 610A; 610B; 723; 724; 725) et fournies au contrôleur mémoire (100; 300; 510; 721), de telle sorte que chacune des premières à N-ièmes données de décision souple (SD; SD0 à SD3) a une taille inférieure à celle de ses données de décision dure correspondantes premières à N-ièmes (HD; HD0 à HD3).

3. Contrôleur mémoire (100; 300; 510; 721) selon la revendication 2, dans lequel le contrôleur mémoire (100; 300; 510; 721) est configuré de telle sorte que les données de décision dure (HD; HD0 à HD3) et les données de décision souple (SD; SD0 à SD3) de chacun des premiers à N-ièmes secteurs soient fournies en continu au circuit ECC (120; 320; 513; 721_2) à partir du formateur de données (130; 310; 300A; 300B; 512; 721_1).

4. Contrôleur mémoire (100; 300; 510; 721) selon la revendication 2, dans lequel le contrôleur mémoire (100; 300; 510; 721) est configuré de telle sorte que les premières à N-ièmes données de décision dure (HD; HD0 à HD3) soient fournies au circuit ECC (120; 320; 513; 721_2) à partir du formateur de données (130; 310; 300A; 300B; 512; 721_1) après que les premières à N-ièmes données de décision souple (SD; SD0 à SD3) ont été fournies au circuit ECC (120; 320; 513; 721_2) à partir du formateur de données (130; 310; 300A; 300B; 512; 721_1).

5. Contrôleur mémoire (100; 300; 510; 721) selon la revendication 2, dans lequel, afin d'effectuer un traitement de décodage normal en utilisant les données de décision dure (HD; HD0 à HD3) sur au moins un des premiers à N-ièmes secteurs sur la première page, le formateur de données (130; 310; 300A; 300B; 512; 721_1) est configuré pour effectuer l'opération de formatage de telle sorte que les données de décision souple (SD; SD0 à SD3) correspondant audit au moins un secteur ne soient pas fournies au circuit ECC (120; 320; 513; 721_2).

6. Contrôleur mémoire (100; 300; 510; 721) selon la revendication 1, dans lequel le formateur de données (130; 310; 300A; 300B; 512; 721_1) est configuré pour
recevoir les premières à N-ièmes données de décision souple (SD; SD0 à SD3) après avoir reçu les premières à N-ièmes données de décision dure (HD; HD0 à HD3), et
effectuer l'opération de formatage de telle sorte que les données de décision souple (SD; SD0 à SD3) de l'un des premiers à N-ièmes secteurs soient fournies au circuit ECC (120; 320; 513; 721_2) avant que les données de décision dure (HD; HD0 à HD3) d'un autre des premiers à N-ièmes secteurs soient fournies au circuit ECC (120; 320; 513; 721_2).

7. Contrôleur mémoire (100; 300; 510; 721) selon la revendication 1, dans lequel le formateur de données (130; 310; 300A; 300B; 512; 721_1) est configuré pour
recevoir au moins une information de décodage sur la base d'un résultat du traitement de décodage ECC, et
effectuer, sur la base de l'information de décodage, l'opération de formatage de telle sorte que les données de décision souple (SD; SD0 à SD3) de certains des premiers à N-ièmes secteurs ne soient pas fournies au circuit ECC (120; 320; 513; 721_2).

8. Contrôleur mémoire (100; 300; 510; 721) selon la revendication 7, dans lequel le contrôleur mémoire (100; 300; 510; 721) est configuré de telle sorte que, lorsque le nombre d'erreurs survenant dans un secteur sur lequel le traitement de décodage ECC a été appliqué en premier parmi les premiers à N-ièmes secteurs est inférieur à une valeur de référence, l'opération de formatage soit effectuée de telle sorte que les données de décision souple (SD; SD0 à SD3) d'un autre des premiers à N-ièmes secteurs ne soient pas fournies au circuit ECC (120; 320; 513; 721_2).

9. Contrôleur mémoire (100; 300; 510; 721) selon la revendication 7, dans lequel le contrôleur mémoire (100; 300; 510; 721) est configuré de telle sorte que, lorsque le nombre d'exécutions de boucle dans le traitement de décodage ECC utilisant les données de décision souple (SD; SD0 à SD3) de l'un des premiers à N-ièmes secteurs dépasse un seuil, l'opération de formatage soit effectuée de telle sorte que les données de décision souple (SD; SD0 à SD3) d'un autre des premiers à N-ièmes secteurs ne soient pas fournies au circuit ECC (120; 320; 513; 721_2).

10. Contrôleur mémoire (100; 300; 510; 721) selon la revendication 1, dans lequel le formateur de données (130; 310; 300A; 300B; 512; 721_1) est configuré pour
recevoir des premières à N-ièmes données de décision dure (HD; HD0 à HD3) et des premières à N-ièmes données de décision souple (SD; SD0 à SD3) pour des premiers à N-ièmes secteurs sur une deuxième page du dispositif mémoire (200; 520; 610A; 610B; 723; 724; 725), et
effectuer l'opération de formatage de telle sorte que les données de décision dure (HD; HD0 à HD3), les données de décision souple (SD; SD0 à SD3) et des données factices de l'un quelconque des premiers à N-ièmes secteurs sur la deuxième page soient fournies en continu au circuit ECC (120; 320; 513; 721_2),
dans lequel chacune des premières à N-ièmes données de décision souple (SD; SD0 à SD3) a été compressée dans le dispositif mémoire (200; 520; 610A; 610B; 723; 724; 725) et a une taille inférieure à celle de ses données de décision dure correspondantes premières à N-ièmes (HD; HD0 à HD3), et
dans lequel une somme de la taille des données de décision souple (SD; SD0 à SD3) et d'une taille des données factices de l'un quelconque des secteurs parmi les premiers à N-ièmes secteurs sur la deuxième page est égale à la taille des données de décision dure (HD; HD0 à HD3) de ce secteur.

11. Contrôleur mémoire (100; 300; 510; 721) selon la revendication 2, dans lequel le formateur de données (130; 310; 300A; 300B; 512; 721_1) est configuré pour
fournir en continu les premières données de décision dure (HDO) et les premières données de décision souple (SDO) du premier secteur au circuit ECC (120; 320; 513; 721_2), et
effectuer l'opération de formatage de telle sorte que des premières données factices (Dummy0) soient fournies au circuit ECC (120; 320; 513; 721_2) à la suite des premières données de décision souple (SD0).

12. Contrôleur mémoire (100; 300; 510; 721) selon la revendication 11, dans lequel la taille des premières données de décision dure (HDO) est égale à la somme de la taille des premières données de décision souple (SDO) et d'une taille des premières données factices (Dummy0).

13. Contrôleur mémoire (100; 300; 510; 721) selon la revendication 11, dans lequel le circuit ECC (120; 320; 513; 721_2) est configuré pour effectuer le traitement de décodage ECC sur le premier secteur lorsque les premières données de décision souple (SDO) sont complètement reçues.

14. Contrôleur mémoire (100; 300; 510; 721) selon la revendication 11, dans lequel : le formateur de données (130; 310; 300A; 300B; 512; 721_1) est configuré pour fournir en continu des deuxièmes données de décision dure (HD1), des deuxièmes données de décision souple (SD1) et des deuxièmes données factices (Dummy1) d'un deuxième secteur au circuit ECC (120; 320; 513; 721_2) après avoir fourni les premières données factices (Dummy0), et
le circuit ECC (120; 320; 513; 721_2) est configuré pour effectuer le traitement de décodage ECC sur le deuxième secteur lorsque les deuxièmes données de décision souple (SD1) sont complètement reçues.

15. Contrôleur mémoire (100; 300; 510; 721) selon la revendication 11, dans lequel :
le contrôleur mémoire (100; 300; 510; 721) est configuré pour émettre, vers le dispositif mémoire (200; 520; 610A; 610B; 723; 724; 725), une commande de lecture pour lire un K-ième secteur parmi les premiers à N-ièmes secteurs sur une deuxième page du dispositif mémoire (200; 520; 610A; 610B; 723; 724; 725) et pour recevoir, à partir du dispositif mémoire (200; 520; 610A; 610B; 723; 724; 725), des K-ièmes données de décision dure du K-ième secteur et les premières à N-ièmes données de décision souple des premiers à N-ièmes secteurs, où K est un entier compris entre 1 et N,
le formateur de données (130; 310; 300A; 300B; 512; 721_1) est configuré pour fournir les K-ièmes données de décision souple parmi les premières à N-ièmes données de décision souple reçues (SD; SD0 à SD3) au circuit ECC (120; 320; 513; 721_2) et pour fournir des K-ièmes données factices au circuit ECC (120; 320; 513; 721_2) à la suite des K-ièmes données de décision souple, et
le circuit ECC (120; 320; 513; 721_2) est configuré pour effectuer le traitement de décodage ECC sur le K-ième secteur lorsque les K-ièmes données de décision souple sont complètement reçues.
